# EUROPÄISCHE PATENTSCHRIFT

(11) **EP 2 562 918 B1**
(45) Veröffentlichungstag und Bekanntmachung des Hinweises auf die Patenterteilung: **24.01.2018**
(21) Anmeldenummer: 12179944.9
(22) Anmeldetag: 09.08.2012
(51) Int. Cl.: H02M 1/08, H03K 17/041, H03K 17/082

(54) **Schaltungsanordnung mit elektronischem Schalter**
Circuit arrangement with electronic switch
Ensemble circuit avec un commutateur électronique

(30) Priorität: 23.08.2011 DE 102011081448
(43) Veröffentlichungstag der Anmeldung: 27.02.2013
(73) Patentinhaber: Bombardier Transportation GmbH, 10785 Berlin (DE)
(72) Erfinder: Lindenmüller, Lars, 01127 Dresden (DE)
(74) Vertreter: Patentanwälte Bressel und Partner mbB

(56) Entgegenhaltungen:
- DE-A1- 4 012 843
- DE-A1-102005 045 099
- JP-A- 5 068 179
- JP-A- S6 395 725
- JP-A- 61 199 324
- US-A- 5 923 547
- US-A1- 2011 181 261
- US-B1- 6 836 414

## Beschreibung

Die Erfindung betrifft eine Schaltungsanordnung mit einem elektronischen Schalter, nämlich einem IGBT, der wiederholt ein- und ausgeschaltet wird, um einen Wechselstromfluss durch eine Induktivität zu bewirken. Der elektronische Schalter kann (zum Beispiel im Gegensatz zu MOSFETs) nur in einer Richtung von Strom durchflossen werden. Außerdem betrifft die Erfindung eine Antriebseinrichtung für ein Fahrzeug, insbesondere ein Schienenfahrzeug, die die Schaltungsanordnung aufweist, und eine Generatoreinrichtung zum Übertragen von elektrischer Energie, die durch einen elektrischen Generator, insbesondere einen durch Wind angetriebenen Generator, erzeugt wird, wobei die Generatoreinrichtung die Schaltungsanordnung aufweist. Die Erfindung betrifft ferner Verfahren zum Betreiben einer solchen Schaltungsanordnung, zum Betreiben der Antriebseinrichtung und zum Betreiben des Generators. Bei der Schaltungsanordnung kann es sich insbesondere um einen Serienresonanzkonverter handeln. Die Erfindung betrifft insbesondere das Gebiet der elektrischen Energieversorgung für Antriebseinrichtungen von Fahrzeugen mit Energie aus einem elektrischen Versorgungsnetz. Die Erfindung ist jedoch auch für andere Zwecke, insbesondere für die Energieübertragung von einer Primärseite auf eine Sekundärseite einer Schaltungsanordnung, einsetzbar. Eine Anwendung betrifft DC/DC-Konverter. Ferner liegt es auf dem Anwendungsgebiet der vorliegenden Erfindung, den elektronischen Schalter bei Frequenzen im Mittelfrequenzbereich (einige 100 Hz bis einige 10 kHz) zu betreiben, d.h. mit dieser Frequenz ein- und auszuschalten.

Für die Versorgung von Antriebseinrichtungen von Schienenfahrzeugen werden je nach Land oder Region elektrische Versorgungsnetze in unterschiedlicher Weise betrieben. Realisiert ist z. B. in Deutschland eine elektrische Versorgung mit Wechselspannung bei einer Frequenz von 16,7 Hz und einer Nennspannung von 15 kV. Ein anderes System wird bei Wechselspannung mit 50 Hz und einer Nennspannung von 25 kV betrieben. Auch existieren Gleichspannungssysteme, insbesondere bei 3 kV und 1,5 kV Nennspannung.

Für den Betrieb an Wechselspannungs-Versorgungsnetzen ist es üblich, die vergleichsweise hohe Wechselspannung des Versorgungsnetzes zunächst über einen Eingangstransformator des Schienenfahrzeugs auf einen niedrigeren Wechselspannungswert herunter zu transformieren, die herunter transformierte Wechselspannung gleichzurichten und in einen so genannten Gleichspannungs-Zwischenkreis einzuspeisen, an dem ein Traktionswechselrichter für den Betrieb eines Traktionsmotors oder mehrerer Traktionsmotoren angeschlossen ist. Nachteilig an dieser Lösung sind aber die Größe und das Gewicht des Eingangstransformators, insbesondere bei Frequenzen von 16,7 Hz, aber auch noch bei Frequenzen von 50 Hz.

Um das Gewicht zu reduzieren kann eine Gleichrichteranordnung für den Betrieb an Wechselspannungsnetzen während des Betriebes an Gleichspannungsnetzen als aktiver Filter betrieben werden. Diese Gleichrichteranordnung weist insbesondere zumindest einen ersten Gleichrichter auf, der ohne galvanische Trennung an das Wechselspannungsnetz angeschlossen wird. Die von dem ersten Gleichrichter erzeugte Gleichspannung wird zu einer Wechselspannung mit höherer Frequenz (insbesondere im Mittelfrequenzbereich von einigen 100 Hz bis einigen 10 kHz) umgerichtet, die Wechselspannung wird der Primärseite eines Transformators zugeführt und die an der Sekundärseite des Transformators anliegende Sekundär-Wechselspannung wird durch einen zweiten Gleichrichter wieder gleichgerichtet und liegt am Gleichspannungszwischenkreis an, aus dem üblicherweise zumindest ein Traktionswechselrichter für den oder die Fahrmotoren des Schienenfahrzeugs gespeist wird/werden. Die erfindungsgemäße Schaltungsanordnung kann z. B. auf der Primärseite des Transformators eingesetzt werden, wobei die Induktivität der Primärseite die eingangs genannte Induktivität sein kann. Insbesondere wenn beim Bremsen des Schienenfahrzeugs der oder die Antriebsmotoren als Stromgenerator betrieben wird/werden, kann die erfindungsgemäße Schaltungsanordnung alternativ oder zusätzlich auf der Sekundärseite des Transformators eingesetzt werden, d.h. in diesem Fall ist die Induktivität auf der Sekundärseite die eingangs genannte Induktivität.

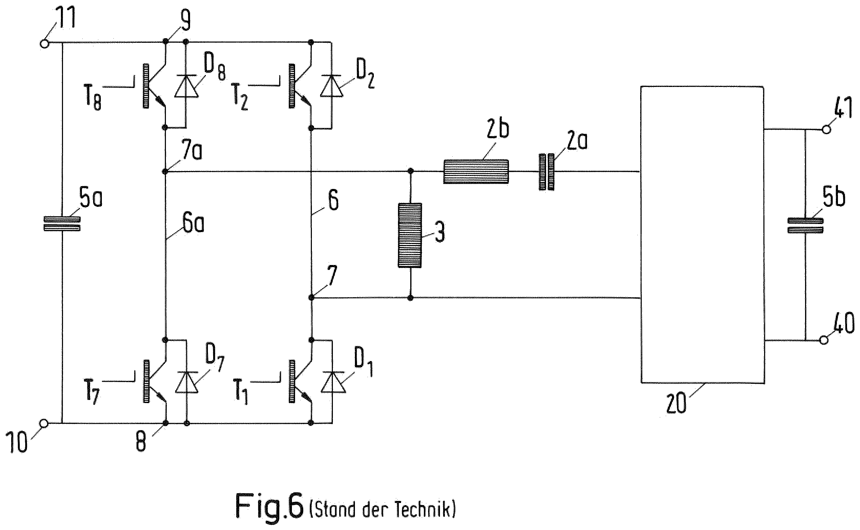

Ein anderer Einsatzzweck ist die Verwendung der Schaltungsanordnung in einem DC/DC-Konverter zur Veränderung des DC-Spannungsniveaus bei der Erzeugung von elektrischer Energie und der Einspeisung der elektrischen Energie in elektrische Versorgungsnetze. Z.B. erzeugt ein windangetriebener Generator eine Wechselspannung, die in eine Ein-Phasen-Gleichspannung umgewandelt wird und dem DC/DC-Konverter zugeführt wird. Dieser gibt an der Ausgangsseite (Sekundärseite) eine erhöhte Gleichspannung ab, so dass die elektrische Energie bei geringeren Verlusten über ein DC-Versorgungsnetz übertragen werden kann und/oder nach erneuter Konversion in eine Wechselspannung ebenfalls mit verringerten Verlusten übertragen werden kann. Solche elektrischen Systeme sind z.B. in der Veröffentlichung "1 MW, 20 kHz, Isolated, Bidirectional 12 kV to 1.2 kV DC-DC Converter for Renewable Energy Applications" von G. Ortiz et al., Proceedings of the 2010 International Power Electronics Conference, Seiten 3212 bis 3219, ISSN 978-1-4244-5393-1/10 beschrieben. Figur 6b auf Seite 3215 der Veröffentlichung beschreibt z.B. einen Serienresonanzkonverter. Figur 6a beschreibt einen DC/DC-Konverter mit Vollbrücke auf der Primärseite eines Transformators. In beiden Schaltungen kann die erfindungsgemäße Schaltungsanordnung eingesetzt werden.

Wenn wie bei den beiden oben beschriebenen Anwendungen (Traktionsenergieversorgung für Fahrzeuge oder Erzeugung und Einspeisung von elektrischer Energie in elektrische Versorgungsnetze) hohe Leistungen zu übertragen sind und dabei die Frequenzen von Schaltvorgängen der beteiligten elektronischen Schalter im Mittelfrequenzbereich liegen, treten beim Ausschalten der elektronischen Schalter Verluste auf, d.h. elektrische Energie wird in Wärme umgewandelt. Insbesondere wenn IGBTs (Insulated Gate Bipolar Transistors) als elektronische Schalter eingesetzt werden, weil große Spannungsfestigkeiten bis zu mehreren kV gefordert sind, treten solche Verluste auf, da sich in dem IGBT nach dem Abschalten noch Ladungsträger befinden, insbesondere so genannte Löcher, d.h. mit weniger Elektronen als möglich besetzte Schalen von Atomen oder Molekülen. Sobald bei einer Halbbrückenschaltung oder Vollbrückenschaltung der andere Schalter bzw. IGBT des Brückenzweiges eingeschaltet wird, liegt an dem zuvor abgeschalteten Schalter eine hohe Spannung an, die die verbliebenen Ladungsträger aus dem Schalter treibt, dabei jedoch die erwähnten Verluste bewirkt.

Eine Möglichkeit, die Verluste zu reduzieren, besteht darin, die Zeit zwischen dem Ausschalten des ersten Schalters und dem Einschalten des zweiten Schalters desselben Brückenzweiges zu verlängern. Dadurch wird jedoch die Energie-Übertragungsleistung reduziert. Eine andere Möglichkeit besteht darin, den Magnetisierungsstrom der Induktivität so einzustellen, dass er nach dem Ausschalten des Schalters die verbliebenen Ladungsträger ausräumt. Ein erhöhter Magnetisierungsstrom bedeutet jedoch eine geringere Effektivität. Beim Betrieb der Schaltungsanordnung kann es außerdem Betriebsphasen geben, in denen weniger Ladungsträger nach dem Ausschalten des Schalters verbleiben. In diesen Betriebsphasen fließt derselbe Magnetisierungsstrom nach dem Ausschalten, der jedoch überdimensioniert ist und daher zu elektrischen Verlusten führt. Wird dagegen der Magnetisierungsstrom z.B. durch entsprechende Ausgestaltung des Transformators kleiner eingestellt, reicht er zwar zum Ausräumen kleiner Ladungsmengen aus, nicht aber zum Ausräumen großer Ladungsmengen in anderen Betriebsphasen.

JP 5068179 A beschreibt eine Ablenkungsschaltung für ein Computerdisplay. Ein erster horizontaler Ausgabe-Transistor, der aus einem IGBT besteht, und ein zweiter horizontaler Ausgabe-Transistor, der aus einem MOSFET besteht, sind einander parallel geschaltet. Eine horizontale Treiberschaltung ist so ausgestaltet, dass der zweite Ausgabe-Transistor in der Schwanzstrom (englisch: tail current) Phase des ersten Ausgabe-Transistors eingeschaltet wird.

JP 61199324 A beschreibt ein Verfahren zum Reduzieren von Steuerleistungsverlusten in einem Transistor-Schaltkreis. Ein erster Steuersignalgenerator steuert einen ersten Transistor und ein zweiter Steuersignalgenerator steuert einen zweiten Transistor. Während ein Ausgangssignal des ersten Steuersignalgenerators sich auf einem niedrigen Niveau befindet, wird ein Pulssignal von dem zweiten Steuersignalgenerator ausgegeben und der zweite Transistor wird eingeschaltet. Wenn der zweite Transistor eingeschaltet ist, wird ein Strompfad kurzgeschlossen, der eine Steuerleistungsversorgung, eine erste Windung eines Transformators und den zweiten Transistor enthält und zu Massepotential führt. Die erste Windung des Transformators ist induktiv mit einer zweiten Windung des Transformators gekoppelt. Durch das Kurzschließen des Strompfades mit der ersten Windung wird eine gespeicherte Ladung von der Basis eines dritten Transistors extrahiert, dessen Basis an die zweite Windung angeschlossen ist. Dadurch wird der dritte Transistor abgeschaltet. Ein Stromkreis, der über eine dritte Windung und eine Diode sowie Kollektor und Emitter des ersten Transistors führt, wobei die dritte Windung induktiv mit der zweiten Windung gekoppelt ist, ist zwar durch den ersten Transistor eingeschaltet. Dennoch fließt noch kein Strom durch den Stromkreis mit der dritten Windung.

DE 10 2005 045 099 A1 beschreibt eine Entsättigungsschaltung für einen IGBT. Dabei wird vor Abschalten des IGBT eine Überschwemmung des Bauelements mit Ladungsträgern reduziert. In der Beschreibungseinleitung der Druckschrift wird ausgeführt, dass IGBTs ein Bipolar-Transistor-Prinzip mit einer leistungslosen Ansteuerung eines MOSFET kombinieren. Dabei wird zur Ansteuerung des IGBT ein Elektronenstrom über einen MOS-Kanal geführt, wobei der Elektronenstrom eine Injektion von Löchern bewirkt. Hierdurch lässt sich im eingeschalteten Zustand des IGBT durch die Injektion die niedrige Leitfähigkeit einer spannungsaufnehmenden Schicht um mehrere Größenordnungen erhöhen. Beim Abschalten des IGBT ist es jedoch erforderlich, dieses leitfähige Plasma zu entfernen, was zwangsläufig zu Abschaltverlusten führt, da während eines Spannungsanstiegs zwischen Emitter und Kollektor des IGBT weiterhin ein Ausräumstrom zum Abbau des Elektronen-Loch-Plasmas fließt. Anhand eines Ausführungsbeispiels werden zeitliche Signalverläufe von dem Laststrom, der Kollektor-Emitter-Spannung, der Gate-Emitter-Spannung sowie des Gatestroms eines IGBT während der Entsättigung und des Abschaltens einer induktiven Last gezeigt. Dabei wird das Gate mit hohem Strom entladen. Die Gatespannung sinkt dabei zunächst unter das Millerplateau ab, was aufgrund der im IGBT gespeicherten Ladungsträger zur Aufrechterhaltung eines konstanten Laststromflusses möglich ist. Eine kurzzeitig abgeschaltete Injektion von Ladungsträgern über den MOSFET im IGBT führt zu einer schnellen Entsättigung. Nach dem Ablauf der Entsättigungszeit fällt der Laststrom ab, indem der Laststrom nach und nach von einer Freilaufdiode übernommen wird. Gegenüber einer anderen Ausführungsform ist der Schwanzstrom reduziert.

DE 40 12 843 A1 beschreibt die Ansteuerung für einen als schnellen Schalter eingesetzten GTO-Thyristor. Zum Sperren des GTO wird eine negative Spannung über einen Schalter an das Gate des GTO angelegt. Bei Wiederkehr der Anoden-Kathoden-Spannung am Ende einer Schonzeit wird über einen zusätzlichen Schalter eine zusätzliche negative Spannung an das Gate des GTO angelegt, die die Gate-Kathoden-Strecke des GTO in Durchbruch bringt.

US 2011/0181261 A1 beschreibt einen Leistungswandler mit einer Steuerschaltung einer ersten Spule, einem ersten elektronisch gesteuerten Schalter, der der ersten Spule zugeordnet ist und auf die Steuerschaltung reagiert. Ein zweiter elektronischer Schalter ist so angeordnet, dass er für einen Kurzschluss der Spule sorgt, wenn er geschlossen ist.

US 6,836,414 B1 beschreibt die Steuerung eines Halbbrücken-DC-DC-Wandlers, um zumindest einen der Schalter bei 0 V zu schalten. Das Wandlersystem ermöglicht ein weiches Schalten aller Schalter, indem ein zusätzlicher Zweig mit einem Schalter und einer Diode über die Primärseite eines isolierenden Transformators hinzugefügt ist.

US 5,923,547 beschreibt einen Leistungswandler mit einem Schaltkreis, der mit einer Primärwindung eines Transformators gekoppelt ist, und einem Gleichrichter, der mit einer Sekundärwindung des Transformators gekoppelt ist. Ein Hilfsschalter auf der Sekundärseite des Transformators erzeugt einen Pfad, um die Streuinduktivität des Transformators zu entladen und den Schaltkreis einfacher bei im Wesentlichen 0-Strom ausschalten zu können.

Es ist eine Aufgabe der vorliegenden Erfindung, eine Schaltungsanordnung mit einem elektronischen Schalter, nämlich einem IGBT, der wiederholt ein- und ausgeschaltet wird, anzugeben, die bei reduzierten Verlusten betrieben werden kann. Eine weitere Aufgabe der vorliegenden Erfindung ist es, ein entsprechendes Verfahren zum Betreiben der Schaltungsanordnung anzugeben.

Die Erfindung betrifft den Fall, dass der elektronische Schalter in einem eingeschalteten Zustand lediglich elektrischen Strom in einer Stromflussrichtung, jedoch nicht in der entgegengesetzten Stromflussrichtung passieren lässt. Dies ist bei bipolaren elektronischen Schaltern der Fall, insbesondere bei IGBTs, aber auch bei bipolaren Transistoren (zum Beispiel npn- oder pnp-Transistoren).

Gemäß einer Grundidee der vorliegenden Erfindung werden in dem elektronischen Schalter, der ein IGBT ist, verbliebene Ladungsträger durch Einschalten eines steuerbaren Zusatzschalters unmittelbar vor, gleichzeitig mit oder nach dem Ausschalten des elektronischen Schalters aus diesem ausgeräumt. Insbesondere wird der steuerbare Zusatzschalter eingeschaltet und damit der Prozess des Ausräumens von Ladungsträgern gestartet, bevor ein etwaig vorhandener zweiter Schalter, der im Fall seines Vorhandenseins für die gewünschte Funktion der Schaltungsanordnung zwingend erforderlich ist (zum Beispiel ein in Reihe zu dem ersten IGBT geschalteter zweiter IGBT), eingeschaltet wird und werden dadurch Ladungsträger aus dem ersten elektronischen Schalter ausgeräumt bzw. lässt dies entgegengesetzt geladene Ladungsträger in dem Schalter rekombinieren. Im Fall der oben erwähnten Halbbrückenschaltung oder Vollbrückenschaltung wird also zunächst der Zusatzschalter eingeschaltet und dann der andere (zweite) Schalter. Der steuerbare Zusatzschalter ist in einem zweiten Stromkreis angeordnet. Insbesondere ist der Zusatzschalter für die gewünschte Funktion der Schaltungsanordnung (zum Beispiel Serienresonanzkonverter) nicht erforderlich, sondern wird verwendet, um die Ladungsträger aus dem ersten elektronischen Schalter (und optional aus zumindest einem weiteren elektronischen Schalter, der für die Funktion der Scheidungsanordnung erforderlich ist) auszuräumen.

Alternativ können die in dem elektronischen Schalter verbliebenen Ladungsträger durch Ausschalten eines steuerbaren Zusatzschalters unmittelbar vor, gleichzeitig mit oder nach dem Ausschalten des elektronischen Schalters aus diesem ausgeräumt werden.

Insbesondere ist/wird die Induktivität, welche bei dem eingeschalteten elektronischen Schalter von elektrischem Strom durchflossen ist, magnetisch mit einer zweiten Induktivität gekoppelt. Bei dieser zweiten Induktivität handelt es sich nicht um die Induktivität auf der Sekundärseite eines Transformators, wenn die Schaltungsanordnung dazu genutzt wird, von der Primärseite eines Transformators auf die Sekundärseite des Transformators Energie zu übertragen. Vielmehr handelt es sich bei der zweiten Induktivität um eine zusätzliche Induktivität, die z.B. durch eine zusätzliche Wicklung einer elektrischen Leitung um den magnetischen Kern der ersten Induktivität bzw. des Transformators realisiert werden kann. Wenn (wie bei einem Transformator) ein ohnehin für die Funktion der Schaltungsanordnung erforderlicher und daher bereits vorhandener Kern (d.h. ein Körper aus einem magnetisierbaren Material zur Führung der magnetischen Feldlinien in dem Transformator, wie z.B. Ferrit) auch für die magnetische Kopplung zwischen dem ersten und dem zweiten Stromkreis genutzt wird oder zu diesem Zweck lediglich modifiziert wird, ist der zusätzliche Aufwand für die magnetische Ankopplung des zweiten Stromkreises besonders gering. Ein Kern muss nicht im klassischen Sinne von sämtlichen Windungen des Transformators umwickelt sein. Allgemeiner formuliert ist ein Kern lediglich ein Bauteil zur Führung der magnetischen Feldlinien.

In diesem Fall ist der steuerbare Zusatzschalter so vorgesehen, dass er in seinem eingeschalteten Zustand einen elektrischen Stromfluss durch die zweite Induktivität ermöglicht, z.B. weil durch das Einschalten des Zusatzschalters die entgegengesetzten Anschlüsse der zweiten Induktivität kurzgeschlossen werden oder über zumindest ein weiteres elektrisches und/oder elektronisches Bauteil verbunden werden.

Der steuerbare Zusatzschalter kann jedoch bei einer alternativen Ausgestaltung, die insbesondere nicht die oben genannte zweite Induktivität aufweist, so vorgesehen sein, dass ein die Ladungsträger aus dem ersten elektronischen Schalter ausräumender elektrischer Strom zumindest teilweise auch durch den steuerbaren Zusatzschalter fließt. Der erste elektronische Schalter und der steuerbare Zusatzschalter sind daher elektrisch miteinander verbunden. Kombinationen beider Ausgestaltungen sind möglich. Zum Beispiel kann sowohl ein steuerbarer Zusatzschalter elektrisch mit dem ersten elektronischen Schalter verbunden sein als auch eine zweite Induktivität vorhanden sein, mit der optional ein weiterer steuerbarer Zusatzschalter verbunden ist.

Durch geeignete Steuerung (insbesondere Wahl der Schaltzeitpunkte für das Ein- und Ausschalten) des Zusatzschalters kann daher zu einem geeigneten Zeitpunkt und/oder in einem geeigneten Zeitraum ein Stromfluss bewirkt werden, der zumindest einen Teil der in dem ersten elektronischen Schalter verbliebenen Ladungsträger ausräumt und insbesondere auch einen Strom durch die zweite Induktivität bewirkt. Dabei wird vorzugsweise ausgenutzt, dass aufgrund der magnetischen Kopplung der ersten Induktivität mit der zweiten Induktivität zumindest zeitweise ein magnetischer Fluss am Ort der zweiten Induktivität vorhanden ist, der nach dem Einschalten des steuerbaren Zusatzschalters einen elektrischen Stromfluss durch die zweite Induktivität bewirkt. Aufgrund der magnetischen Kopplung verändert dieser Stromfluss durch die zweite Induktivität aber den magnetischen Fluss und induziert auf diese Weise einen elektrischen Strom durch die erste Induktivität, der zum Ausräumen der verbliebenen Ladungsträger nach dem Ausschalten des ersten elektronischen Schalters genutzt wird. Dabei wird zwar bevorzugt, dass durch Steuerung des Zusatzschalters und den dadurch bewirkten Strom durch die erste Induktivität die Ladungsträger in dem ausgeschalteten ersten elektronischen Schalter vollständig ausgeräumt werden. Jedoch umfasst die Erfindung auch Fälle, in denen dieser Zusatzstrom die Ladungsträger nicht vollständig ausräumt.

Insbesondere wenn der Zusatzschalter vor dem Ausschalten des ersten elektronischen Schalters eingeschaltet wird, kann das Einschalten zum Beispiel zeitgesteuert durchgeführt werden. Dies ist insbesondere dann möglich, wenn die Schaltungsanordnung (wie bei Resonanzkonvertern) periodisch betrieben wird, das heißt der erste elektronische Schalter periodisch ein- und ausgeschaltet wird. Zum Beispiel hat der Strom durch den ersten elektronischen Schalter in diesem Fall einen sinusförmigen Zeitverlauf. Insbesondere liegt beim periodischen Betrieb im Vorhinein fest, wann der Strom durch den ersten elektronischen Schalter nach dem Erreichen seines Maximums lediglich noch 10 % (oder ein anderer Prozentsatz) seines Maximums beträgt. Insbesondere kann der Zeitpunkt für das Einschalten des Zusatzschalters bei Vorhandensein eines Taktgenerators (so genannte Clock) durch die Anzahl der Takte seit dem vorangegangenen Einschalten des ersten elektronischen Schalters vorgegeben sein. Alternativ oder zusätzlich kann jedoch der Strom durch den ersten elektronischen Schalter gemessen werden und bei Erreichen eines vorgegebenen Wertes (der zum Beispiel 10 % oder weniger als der vorangegangene Maximalwert des Stromes beträgt) der Zusatzschalter eingeschaltet werden. Wenn der Zusatzschalter nach dem Ausschalten des ersten elektronischen Schalters eingeschaltet werden soll, kann dies insbesondere durch eine Verzögerung (das heißt ein vorgegebenes Verzögerungs-Zeitintervall) festgelegt werden, um die der Zusatzschalter verzögert nach dem ausschalten des ersten elektronischen Schalters eingeschaltet wird. Eine entsprechende Verzögerungsschaltung ist Stand der Technik und kann zum Beispiel durch ein FPGA (Field Programmable Gate Array) realisiert werden.

Bei einer Variante des zuvor beschriebenen Verfahrens bzw. bei einer Variante der Schaltungsanordnung kann eine Zusatzspannung, die über die zweite Induktivität abfällt, dazu verwendet werden, den Strom durch die zweite Induktivität zu treiben oder gemeinsam mit dem erwähnten magnetischen Fluss der magnetischen Kopplung den Strom durch die zweite Induktivität zu treiben. Allerdings wird der Einsatz einer Zusatzspannung nicht bevorzugt, da er den Einsatz zusätzlicher Energie bedeutet. Jedoch handelt es sich dabei um eine Möglichkeit, einen Stromfluss durch die erste Induktivität zu induzieren, ohne unmittelbar in den Stromkreis einzugreifen, in dem der erste elektronische Schalter und die erste Induktivität angeordnet sind.

Der erste elektronische Schalter wird insbesondere erst dann ausgeschaltet, wenn sein Laststrom (zum Beispiel der Kollektor-Emitter Strom eines IGBTs) klein ist oder null ist. Insbesondere ist der Laststrom klein, wenn er kleiner als 10 %, vorzugsweise kleiner als 5 % und insbesondere kleiner als 2 % eines Strom- Maximalwertes ist, den der Laststrom zuvor erreicht hat, wobei der Laststrom nach dem Verlassen des Maximalwertes stetig abnimmt, bis der erste elektronische Schalter ausgeschaltet wird. Eine solche stetige Abnahme des Laststroms ist zum Beispiel in jedem Zyklus eines sich zyklisch wiederholenden Prozesses einer Schaltungsanordnung zu beobachten, die den ersten elektronischen Schalter als aktives Schaltelement enthält, zum Beispiel bei zyklisch schaltenden Stromrichtern. Die Erfindung betrifft insbesondere solche Stromrichter und die entsprechenden Betriebsverfahren zum Betreiben solcher Stromrichter. Insbesondere wird der Zusatzschalter auch erst dann ausgeschaltet, wenn der Laststrom in diesem Sinne klein ist oder null ist.

Zum Beispiel können in einem Serienresonanzkonverter, dessen Betrieb anhand der Figuren noch näher erläutert wird, das Einschalten und das Ausschalten vorzugsweise sämtlicher steuerbarer Schalter (insbesondere des ersten elektronischen Schalters und des Zusatzschalters) durch sich insbesondere periodisch wiederholende Pulsmuster (die Pulse sind die Steuersignale, um das Einschalten oder Ausschalten auszulösen) realisiert werden. Das jeweilige Pulsmuster, welches für den Betrieb einer Schaltungsanordnung verwendet wird, gibt die zeitliche Abfolge der Schaltvorgänge vor.

Durch das Abschalten des ersten elektronischen Schalters bei kleinem Laststrom werden Schaltverluste reduziert. Im Gegensatz zu einem so genannten harten Abschalten bei hohem Laststrom tritt aber das oben erwähnte Problem der in dem ersten elektronischen Schalter verbliebenen Ladungsträger auf, die ebenfalls zu Schaltverlusten führen, wenn z. B. ein zweiter elektronischer Schalter, der für den Betrieb der Schaltungsanordnung erforderlich ist, eingeschaltet wird, um z. B. den Strom durch die erste Induktivität umzukehren oder wieder zu erhöhen. Durch Einschalten des Zusatzschalters werden die Ladungsträger ausgeräumt und somit die Schaltverluste weiter reduziert.

Ferner wird es bevorzugt, dass der Zusatzschalter lediglich dann eingeschaltet ist, wenn kein Laststrom mehr durch den ersten elektronischen Schalter fließt und der erste elektronische Schalter ausgeschaltet ist. Dies ist allerdings nicht zwingend erforderlich. Z.B. kann der Zusatzschalter auch kurz vor dem Ausschalten des ersten elektronischen Schalters eingeschaltet werden, insbesondere weil der Stromfluss durch die zweite Induktivität aufgrund des Effekts der Selbstinduktion zunächst nur bei geringen Stromstärken fließt.

Entsprechendes gilt für den Fall, dass ein zweiter elektronischer Schalter, der in Reihe zu dem ersten elektronischen Schalter geschaltet ist, nach einer Wartezeit seit dem Ausschalten des ersten elektronischen Schalters eingeschaltet wird. Vorzugsweise wird der Zusatzschalter vor dem Einschalten des zweiten elektronischen Schalters wieder ausgeschaltet. Insbesondere wenn die verbliebenen Ladungsträger in dem ersten elektronischen Schalter aber bereits vollständig ausgeräumt sind, kann der Zusatzschalter auch kurz nach dem Einschalten des zweiten elektronischen Schalters ausgeschaltet werden.

Wenn in den vorangegangenen Absätzen von dem Ausschalten des ersten elektronischen Schalters die Rede ist, ist damit der entsprechende Steuervorgang des Schalters gemeint. Im Fall eines IGBT wird zur Ansteuerung des Schalters der Ladungszustand des Gates verändert, das heißt es fließt ein elektrischer Gate-Strom. Mit dem Zeitpunkt des Ausschaltens ist der Zeitpunkt gemeint, an dem der Steuervorgang beginnt, z. B. weil eine Treiberschaltung, die den Steuervorgang ausführt, ein Schaltsignal von einer übergeordneten Steuerung erhalten hat. Insbesondere beginnt der Steuervorgang daher mit dem Erhalt des Schaltsignals (z. B. des Pulses des Pulsmusters).

Die Erfindung hat den Vorteil, dass durch geeignete Steuerung des Zusatzschalters verbliebene Ladungsträger nach dem Ausschalten des ersten elektronischen Schalters aus diesem ausgeräumt werden können, ohne dass eine hohe elektrische Spannung während des Ausräumens der Ladungsträger über dem ersten elektronischen Schalter abfällt. Wie erwähnt würde eine solche hohe elektrische Spannung über dem ersten elektronischen Schalter abfallen, wenn ein in Reihe dazu geschalteter zweiter elektronische Schalter eingeschaltet wird. Insbesondere bei mittelfrequenten (einige kHz) Schaltvorgängen kann die Einschaltdauer des Zusatzschalters nach dem Abschalten des ersten elektronischen Schalters oder teilweise vor und teilweise nach dem Abschalten des ersten elektronischen Schalters immer gleich groß sein. Alternativ kann diese Zeitdauer variieren, wobei die Zeitdauer in diesem Fall vorzugsweise größer ist, wenn eine größere Ladungsträgermenge aus dem ersten elektronischen Schalter auszuräumen ist. Aber auch bei gleichbleibender Zeitdauer können unterschiedlich große Mengen der verbliebenen Ladungsträger aus dem ersten elektronischen Schalter ausgeräumt werden, ohne erhebliche Zusatzverluste zu erzeugen, wie es bei einem großen Magnetisierungsstrom der Fall wäre.

Im Fall der zweiten Induktivität liegt der Grund dafür darin, dass der Stromfluss durch die zweite Induktivität zu keiner vergleichbar großen elektrischen Spannung über den ersten elektronischen Schalter führt, wie es nach dem Einschalten eines in Reihe geschalteten zweiten elektronischen Schalters der Fall wäre. Bleibt der steuerbare Zusatzschalter noch eingeschaltet, weil die Einschaltdauer noch nicht erreicht ist, und sind die in dem ersten elektronischen Schalter verbliebenen Ladungsträger bereits ausgeräumt, dann liegt dort bereits eine Spannung an und der Ausräumstrom hört von alleine auf zu fließen. Alternativ oder zusätzlich kann immer derselbe Zeitpunkt für das Einschalten des Zusatzschalters gewählt werden, bezogen auf den Zeitpunkt des Ausschaltens des ersten elektronischen Schalters.

Insbesondere wird Folgendes vorgeschlagen: Eine Schaltungsanordnung, aufweisend:
- einen ersten elektronischen Schalter, der im eingeschalteten Zustand des elektronischen Schalters (T₁) lediglich elektrischen Strom in einer Stromflussrichtung, jedoch nicht in der entgegengesetzten Stromflussrichtung passieren lässt, insbesondere einen IGBT,
- optional eine erste Induktivität,
- zumindest Teile eines ersten Stromkreises, in dem während dem Betrieb der Anordnung bei eingeschaltetem erstem elektronischem Schalter ein elektrischer Strom durch den ersten elektronischen Schalter und insbesondere auch durch die erste Induktivität fließt,
- eine erste Steuerung zum Ein- und Ausschalten des ersten elektronischen Schalters, wobei die erste Steuerung ausgestaltet ist, den ersten elektronischen Schalter wiederholt ein- und auszuschalten,
- einen steuerbaren Zusatzschalter, der durch die erste Steuerung oder durch eine zusätzliche zweite Steuerung steuerbar ist,
wobei die erste Steuerung und die Steuerung des Zusatzschalters derart ausgestaltet sind, dass der erste elektronische Schalter insbesondere erst dann ausgeschaltet wird und der Zusatzschalter insbesondere erst dann eingeschaltet wird, wenn der Laststrom durch den ersten elektronischen Schalter kleiner als 10 % eines Strom- Maximalwertes ist, den der Laststrom zuvor erreicht hat, wobei der Laststrom nach dem Verlassen des Strom-Maximalwertes stetig abgenommen hat,
und wobei durch Einschalten des Zusatzschalters Ladungsträger, die in dem ersten elektronischen Schalter nach dessen Ausschalten verblieben sind, aus diesem ausgeräumt werden.

Vorzugsweise weist die Schaltungsanordnung auf:
- eine zweite Induktivität, die magnetisch mit der ersten Induktivität gekoppelt ist,
- einen zweiten Stromkreis, in dem die zweite Induktivität angeordnet ist, und
wobei der Zusatzschalter in dem zweiten Stromkreis angeordnet ist, sodass durch Einschalten des Zusatzschalters und durch die magnetische Kopplung der zweiten Induktivität mit der ersten Induktivität ein Strom fließt, der in dem ersten elektronischen Schalter verbliebene Ladungsträger aus diesem ausgeräumt.

Insbesondere ist der Zusatzschalter (und damit der zweite Stromkreis) während Zeitintervallen eingeschaltet, in denen der erste elektronische Schalter ausgeschaltet ist.

Insbesondere kann der Zusatzschalter gleichzeitig mit dem Ausschalten des Hauptschalters eingeschaltet werden. Dies ist jedoch nicht zwingend erforderlich. Je nach Art des Zusatzschalters kann er auch vor dem Ausschalten des Hauptschalters eingeschaltet werden. Ferner ist es möglich, den Zusatzschalter nach dem Ausschalten des Hauptschalters einzuschalten.

Insbesondere kann der zweite Stromkreis von dem ersten Stromkreis elektrisch getrennt sein. Dies ist jedoch nicht zwingend erforderlich. Die zweite Induktivität kann daher entfallen. In diesem Fall wird die erste Induktivität jedenfalls nicht für die magnetische Kopplung mit der zweiten Induktivität benötigt.

Außerdem gehört zum Umfang der Erfindung eine Antriebseinrichtung für ein Fahrzeug, insbesondere ein Schienenfahrzeug, wobei die Antriebseinrichtung die Schaltungsanordnung in einer ihrer Ausgestaltungen aufweist und über einen netzseitigen Anschluss elektrisch oder magnetisch an ein elektrisches Versorgungsnetz anschließbar ist, wobei die Schaltungsanordnung mit dem ersten Stromkreis an den netzseitigen Anschluss angeschlossen ist und ein motorseitiger Anschluss der Schaltungsanordnung magnetisch mit der ersten Induktivität verbunden ist, sodass beim Betrieb des Fahrzeugs Energie von dem netzseitigen Anschluss über die erste Induktivität und den motorseitigen Anschluss zu einem Antriebsmotor des Fahrzeugs übertragbar ist.

Auch gehört zum Umfang der Erfindung eine Generatoreinrichtung zum Übertragen von elektrischer Energie, die durch einen elektrischen Generator, insbesondere einen durch Wind angetriebenen Generator, erzeugt wird, wobei die Generatoreinrichtung die Schaltungsanordnung in einer ihrer Ausgestaltungen aufweist und über einen generatorseitigen Anschluss an den Generator anschließbar ist, wobei die Schaltungsanordnung mit dem ersten Stromkreis an den generatorseitigen Anschluss angeschlossen ist und ein netzseitiger Anschluss der Schaltungsanordnung zum Anschließen an ein elektrisches Versorgungsnetz magnetisch mit der ersten Induktivität verbunden ist, sodass beim Betrieb des Generators Energie von dem generatorseitigen Anschluss über die erste Induktivität über den netzseitigen Anschluss zu dem elektrischen Versorgungsnetz übertragbar ist.

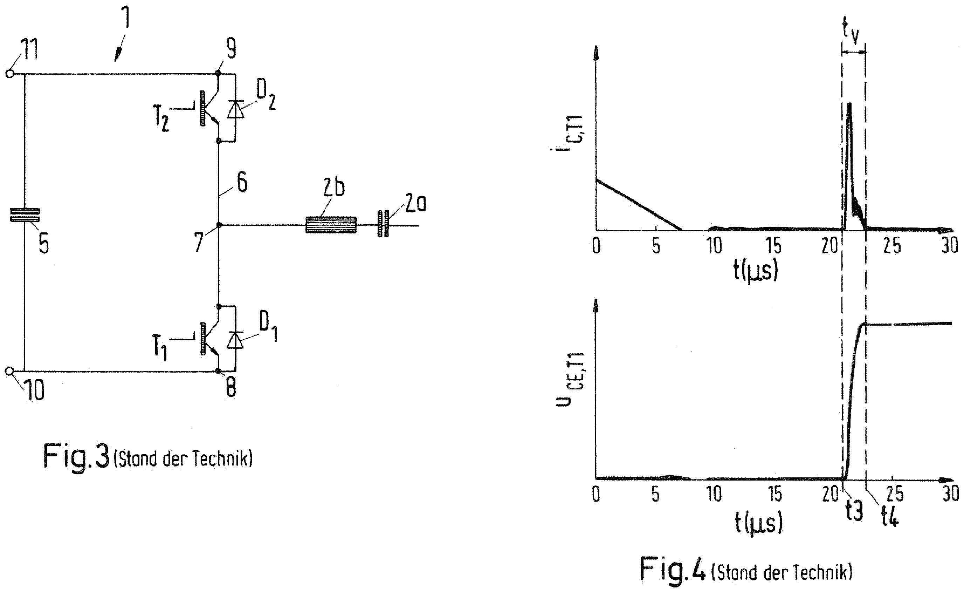

Weiterhin gehört zum Umfang der vorliegenden Erfindung ein Serienresonanzkonverter, der die Schaltungsanordnung in einer ihrer Ausgestaltungen aufweist, wobei die erste Induktivität zur magnetischen Kopplung der Primärseite und der Sekundärseite des Konverters genutzt wird. Insbesondere kann es sich bei dem Serienresonanzkonverter um einen Konverter handeln, der im Mittelspannungsbereich betrieben wird, wie in der Veröffentlichung "A BiDirectional Isolated DC/DC Converter as a Core Circuit of the Next-Generation Medium-Voltage Power Conversion System" von S. Inoue. und H. Akagi, veröffentlicht auf der Power Electronics Specialists Conference, 2006, beschrieben wird (z. B. anhand von Fig. 3(b) der Veröffentlichung).

Ferner wird ein Verfahren zum Betreiben einer Schaltungsanordnung (und insbesondere auch der Antriebseinrichtung oder der Generatoreinrichtung) vorgeschlagen, die Folgendes aufweist:
- einen ersten elektronischen Schalter, der im eingeschalteten Zustand des elektronischen Schalters (T₁) lediglich elektrischen Strom in einer Stromflussrichtung, jedoch nicht in der entgegengesetzten Stromflussrichtung passieren lässt, insbesondere einen IGBT,
- optional eine erste Induktivität,
- zumindest Teile eines ersten Stromkreises, in dem der erste elektronische Schalter und - sofern vorhanden - die erste Induktivität angeordnet sind,
wobei der erste elektronische Schalter wiederholt ein- und ausgeschaltet wird und dadurch bei eingeschaltetem erstem elektronischem Schalter ein elektrischer Strom durch den ersten elektronischen Schalter und insbesondere auch durch die erste Induktivität fließt. Der erste elektronische Schalter wird insbesondere erst dann ausgeschaltet und ein Zusatzschalter wird insbesondere erst dann eingeschaltet wird, wenn der Laststrom durch den ersten elektronischen Schalter kleiner als 10 % eines Strom- Maximalwertes ist, den der Laststrom zuvor erreicht hat, wobei der Laststrom nach dem Verlassen des Strom-Maximalwertes stetig abgenommen hat. Ferner werden durch Einschalten des Zusatzschalters nach dem Ausschalten des ersten elektronischen Schalters in diesem verbliebene Ladungsträger aus diesem ausgeräumt.

Die erste Induktivität kann mit einer zweiten Induktivität magnetisch gekoppelt betrieben werden, wobei die zweite Induktivität in einem zweiten Stromkreis angeordnet ist, der z. B. von dem ersten Stromkreis elektrisch getrennt sein kann. Durch das Einschalten des Zusatzschalters und durch die magnetische Kopplung der zweiten Induktivität mit der ersten Induktivität fließt ein Strom, der in dem ersten elektronischen Schalter verbliebene Ladungsträger aus diesem ausräumt insbesondere kann durch Einschalten zumindest eines Zusatzschalters ein Stromfluss während Zeitintervallen erzeugt werden, in denen der erste elektronische Schalter ausgeschaltet ist, um die Ladungsträger aus diesem auszuräumen.

Wie oben erwähnt, kann das Einschaltintervall, während dem der Zusatzschalter eingeschaltet ist, optional vor dem jeweiligen Zeitintervall beginnen, in dem der erste elektronische Schalter ausgeschaltet ist.

Insbesondere kann die erste Steuerung, die dem Ein- und Ausschalten des ersten elektronischen Schalters dient, entweder auch die Steuerung des Zusatzschalters sein oder mit einer zweiten Steuerung verbunden sein, die die Steuerung des Zusatzschalters ist. Wenn zwei Steuerungen vorhanden sind, sind diese vorzugsweise so miteinander verbunden, dass der zeitliche Ablauf der von den Steuerungen ausgeführten Steuerprozesse (insbesondere Ausgabe der Signale an die zu schaltenden Schalter und damit Festlegung der Schaltzeitpunkte) koordiniert werden kann. Insbesondere kann die erste Steuerung auf diese Weise die Information darüber an die zweite Steuerung übertragen, dass und/oder wann der erste elektronische Schalter ausgeschaltet wurde oder das entsprechende Signal ausgegeben wurde. Unter Verwendung dieser Information kann die zweite Steuerung festlegen, dass und/oder wann der Zusatzschalter eingeschaltet wird. Insbesondere kann der Zusatzschalter gleichzeitig mit dem Ausschalten des ersten elektronischen Schalters eingeschaltet werden, gegebenenfalls geringfügig verzögert durch die Zeitspanne, die für die Übertragung der Information von der ersten Steuerung zu der zweiten Steuerung und das Ausführen des entsprechenden Steuerprozesses durch die zweite Steuerung erforderlich ist. Wenn der Zusatzschalter von der ersten Steuerung gesteuert wird, gilt entsprechendes wie zuvor beschrieben. Es ist lediglich nicht mehr notwendig, dass die erste Steuerung ein Signal an eine zweite Steuerung ausgibt. Z.B. kann die Steuerlogik der ersten und/oder zweiten Steuerung durch Software eines entsprechenden Computers ausgeführt werden. In diesem Fall erzeugt die Software z.B. gleichzeitig den Befehl zum Ausschalten des ersten elektronischen Schalters und den Befehl zum Einschalten des Zusatzschalters. Für das Ausschalten des Zusatzschalters kann z.B. eine fest vorgegebene Zeitspanne berücksichtigt werden, die zwischen dem Einschalten des Zusatzschalters und dem Ausschalten des Zusatzschalters vergeht. Im Fall einer Steuersoftware wird die Zeit seit dem Einschalten des Zusatzschalters gemessen (z.B. durch Zählen der Anzahl von Arbeitstakten des Computers) und wird zu einem entsprechenden Zeitpunkt der Befehl zum Ausschalten des Zusatzschalters erteilt.

Bei der ersten Induktivität kann es sich insbesondere um die Induktivität auf der Primärseite eines Transformators handeln, wobei der magnetische Kern des Transformators vorzugsweise auch für die magnetische Kopplung zwischen der ersten Induktivität und (wenn vorhanden) der zweiten Induktivität in dem zweiten Stromkreis genutzt wird. Die Schaltungsanordnung weist daher einen Transformator auf, wobei die erste Induktivität Teil des Transformators auf einer Primärseite des Transformators ist. Dies schließt nicht aus, dass sich auf der Primärseite des Transformators eine weitere Induktivität in einem weiteren Stromkreis befindet, der von dem ersten Stromkreis getrennt ist.

Zu dem ersten Stromkreis gehören abgesehen von den erforderlichen elektrischen Leitungsverbindungen der erste elektronische Schalter und optional auch die erste Induktivität. Bei eingeschaltetem elektronischem Schalter fließt ein Strom sowohl durch den ersten elektronischen Schalter als auch durch die erste Induktivität. Ferner kann der erste Stromkreis zumindest einen Kondensator aufweisen, der in Reihe zu der ersten Induktivität geschaltet ist, so dass die erste Induktivität und der zumindest eine Kondensator einen Reihenschwingkreis bilden. Dies ist z.B. bei einem so genannten Serienresonanzkonverter der Fall. Außerdem kann zumindest ein Kondensator vorhanden sein, der zwischen die verschiedenen elektrischen Potenziale einer Gleichspannung geschaltet ist, welche an der Primärseite der Schaltungsanordnung anliegt und den Stromfluss durch den ersten elektronischen Schalter und die erste Induktivität bewirkt. Die entsprechende Spannungsquelle gehört mit zu dem ersten Stromkreis, nicht aber zwangsläufig zu der erfindungsgemäßen Schaltungsanordnung.

Vorzugsweise weist die Schaltungsanordnung einen zweiten elektronischen Schalter auf, der über eine elektrisch leitende Verbindung mit dem ersten elektronischen Schalter zu einer ersten Reihenschaltung verbunden ist, wobei ein erster Anschluss der ersten Induktivität elektrisch mit der elektrisch leitenden Verbindung der ersten Reihenschaltung verbunden sein kann und wobei die erste Steuerung oder die zusätzliche zweite Steuerung derart zum Ein- und Ausschalten des Zusatzschalters ausgestaltet ist, dass der Zusatzschalter (und optional damit auch der zweite Stromkreis) während Zeitintervallen eingeschaltet ist, in denen sowohl der erste elektronische Schalter als auch der zweite elektronische Schalter ausgeschaltet ist.

Gemäß einem entsprechenden Verfahren werden der erste elektronische Schalter und ein zweiter elektronischer Schalter der Schaltungsanordnung, der über eine elektrisch leitende Verbindung mit dem ersten elektronischen Schalter zu einer ersten Reihenschaltung verbunden ist, wechselweise ein- und ausgeschaltet, sodass jeweils bei einem eingeschalteten Schalter ein elektrischer Strom durch die optional elektrisch mit der elektrisch leitenden Verbindung der ersten Reihenschaltung verbundene erste Induktivität fließen kann, und wobei durch Ein- und Ausschalten zumindest eines Zusatzschalters in dem zweiten Stromkreis ein Stromfluss während Zeitintervallen erzeugt wird, in denen sowohl der erste elektronische Schalter als auch der zweite elektronische Schalter ausgeschaltet ist.

Der Zeitraum zwischen dem Ausschalten des ersten elektronischen Schalters und dem Einschalten des zweiten elektronischen Schalters wurde oben bereits als Wartezeit bezeichnet. Eine solche Wartezeit wird üblicherweise bereits deshalb eingehalten, weil sicher ausgeschlossen sein muss, dass die beiden elektronischen Schalter gleichzeitig eingeschaltet sind. Vorzugsweise ist die Schaltungsanordnung so ausgelegt (insbesondere durch entsprechende Ausgestaltung der magnetischen Kopplung zwischen der ersten Induktivität und der zweiten Induktivität durch geeignete Wahl der zweiten Induktivität und durch entsprechende Steuerung des Zusatzschalters), dass die nach dem Ausschalten in den ersten elektronischen Schalter verbliebenen Ladungsträger während der Wartezeit vollständig ausgeräumt werden. Aber auch dann, wenn die Ladungsträger nicht vollständig ausgeräumt werden, sind die elektrischen Verluste gegenüber vorbekannten Lösungen reduziert. Die restlichen verbliebenen Ladungsträger, die nach dem Einschalten des zweiten elektronischen Schalters noch in dem ersten elektronischen Schalter vorhanden sind, werden aufgrund der sich dann über den ersten elektronischen Schalter aufbauenden elektrischen Spannung ausgeräumt.

Bei der Reihenschaltung mit den zwei über die elektrisch leitende Verbindung miteinander verbundenen elektronischen Schaltern befindet sich typischerweise an den entgegengesetzten Enden der Reihenschaltung die Gleichspannung, welche den Stromfluss durch den jeweils eingeschalteten elektronischen Schalter und die optionale erste Induktivität treibt. Auf Ausführungsbeispiele wird noch eingegangen. Wie üblich kann zu jedem der elektronischen Schalter eine Freilaufdiode antiparallel geschaltet sein.

Z. B. ist der Zusatzschalter ein IGBT, ein MOSFET (Metal-Oxide-Semiconductor Field-Effect Transistor) oder ein Thyristor.

Dies ist eine Möglichkeit, wie die Schaltungsanordnung auch nach dem Abschalten des zweiten elektronischen Schalters, der in Reihe zu dem ersten elektronischen Schalter geschaltet ist (siehe oben), zum Ausräumen von Ladungsträgern aus dem zweiten elektronischen Schalter genutzt werden kann. Eine andere Möglichkeit wäre es, einen weiteren, dritten Stromkreis vorzusehen, der einen weiteren Zusatzschalter und z. B. eine weitere Induktivität aufweist, die magnetisch mit der ersten Induktivität gekoppelt ist, wobei der weitere Stromkreis optional elektrisch von dem ersten Stromkreis getrennt ist. Noch eine weitere Möglichkeit ist es, eine Richtung des Stromflusses in dem zweiten Stromkreis abhängig davon zu steuern, ob vorangehend ein Strom durch den ersten oder zweiten elektronischen Schalter geflossen ist. Dem entspricht eine Schaltungsanordnung, bei der der zweite Stromkreis einen ersten und einen zweiten Zusatzschalter aufweist, wobei der erste Zusatzschalter in seinem eingeschalteten Zustand einen Stromfluss durch den zweiten Stromkreis in einer ersten Richtung ermöglicht und der zweite Zusatzschalter in seinem eingeschalteten Zustand einen Stromfluss durch den zweiten Stromkreis in der entgegen gesetzten Richtung ermöglicht. Allen möglichen Lösungen liegt das Problem zugrunde, dass beim Betrieb der Reihenschaltung mit den zwei in Reihe geschalteten elektronischen Schaltern der Stromfluss durch den ersten Stromkreis bei eingeschaltetem ersten elektronischen Schalter in eine Richtung fließt und bei eingeschaltetem zweiten elektronischen Schalter in die entgegengesetzte Richtung fließt. Dementsprechend würde auch beim Ausräumen der verbliebenen Ladungsträger in den elektronischen Schaltern der entsprechende Strom durch die zweite Induktivität in umgekehrte Richtung fließen. Beim Einsatz direktionaler Schalter muss bei Verwendung des zweiten Stromkreises für das Ausräumen beider elektronischer Schalter zumindest der Stromfluss durch einen Teil des zweiten Stromkreises abhängig davon verändert werden, aus welchem elektronischen Schalter Ladungsträger auszuräumen sind.

Ausführungsbeispiele der Erfindung werden nun unter Bezugnahme auf die beigefügte Zeichnung beschrieben. Die einzelnen Figuren der Zeichnung zeigen:
- Fig. 1: eine vereinfacht dargestellte Schaltungsanordnung mit zwei in Reihe zueinander geschalteten elektronischen Schaltern, wobei an den entgegengesetzten Anschlüssen der Reihenschaltung eine Gleichspannung angelegt ist, wobei eine Induktivität elektrisch mit einem Anschluss zwischen den in Reihe zueinander geschalteten elektronischen Schaltern verbunden ist und wobei die Schaltungsanordnung dem Stand der Technik entspricht,
- Fig. 2: ein Zeitdiagramm, das den zeitlichen Verlauf von verschiedenen elektrischen Größen der Schaltungsanordnung gemäß Fig. 1 zeigt und ebenfalls dem Stand der Technik entspricht,
- Fig. 3: eine Schaltungsanordnung gemäß dem Stand der Technik ähnlich der in Fig. 1, wobei jedoch statt der ersten Induktivität ein externes Netzwerk mit einer Induktivität und einer Kapazität, zum Beispiel ein Serienresonanzkreis, dargestellt ist,
- Fig. 4: ein Zeitdiagramm, das den zeitlichen Verlauf von verschiedenen elektrischen Größen der Schaltungsanordnung gemäß Fig. 3 zeigt und ebenfalls dem Stand der Technik entspricht,
- Fig. 5: ein konkretes Ausführungsbeispiel der vereinfacht in Fig. 3 dargestellten Schaltungsanordnung gemäß dem Stand der Technik,
- Fig. 6: eine Variante der in Fig. 5 dargestellten Schaltungsanordnung gemäß dem Stand der Technik, bei der zwischen die Anschlusspunkte der Vollbrücke eine Induktivität geschaltet ist,
- Fig. 7: eine weitere Schaltungsanordnung gemäß dem Stand der Technik, nämlich einen Serienresonanzkonverters mit einem DC/DC-Konverter mit Vollbrücken auf beiden Seiten des Transformators,
- Fig. 8: eine erfindungsgemäße Schaltungsanordnung ähnlich den in Fig. 5 und Fig. 6 dargestellten Serienresonanzkonvertern,
- Fig. 9: ein Diagramm ähnlich dem in Fig. 4, wobei jedoch die erfindungsgemäße Schaltungsanordnung zum Einsatz kommt und wobei der Zeitverlauf schematisch dargestellt ist,
- Fig. 10: eine weitere erfindungsgemäße Schaltungsanordnung, nämlich einen Serienresonanzkonverter, wobei in Abänderung der Schaltungsanordnung in Fig. 8 die erfindungsgemäße Schaltungsanordnung als separater zweiter Stromkreis, der über magnetisch gekoppelte Induktivitäten angeschlossen wird, ausgeführt ist,
- Fig. 11: eine weitere Schaltungsanordnung, nämlich einen DC/DC-Konverter mit Vollbrücken auf beiden Seiten des Transformators, wobei ebenfalls der separate zweite Stromkreis mit der zweiten Induktivität und dem Zusatzschalter vorgesehen ist,
- Fig. 12: eine weitere Schaltungsanordnung, nämlich einen DC/DC-Konverter mit Halbbrücken auf beiden Seiten des Transformators, wobei ebenfalls der separate zweite Stromkreis mit der zweiten Induktivität und dem Zusatzschalter vorgesehen ist,
- Fig. 13: einen ersten Betriebszustand der in Fig. 12 dargestellten Schaltungsanordnung, während der erste elektronische Schalter eingeschaltet ist,
- Fig. 14: einen zweiten Betriebzustand der in Fig. 12 und Fig. 13 dargestellten Schaltungsanordnung, nach dem Ausschalten des ersten elektronischen Schalters und nach dem Einschalten des Zusatzschalters in dem zweiten Stromkreis,
- Fig. 15: Messergebnisse von elektrischen Größen im Zeitraum eines Schaltvorgangs in einem Serienresonanzkonverter entsprechend Fig. 12-14, wenn der Zusatzschalter nicht betätigt wird und dauerhaft geöffnet bleibt und die Betriebsweise daher dem Stand der Technik entspricht,
- Fig. 16: Messergebnisse von elektrischen Größen im Zeitraum eines Schaltvorgangs in einem Serienresonanzkonverter entsprechend Fig. 12-14, wenn der Zusatzschalter betätigt wird, um Ladungsträger aus dem ausgeschalteten Schalter auszuräumen,
- Fig. 17 - 22: schematische Darstellungen von Ausgestaltungen des zweiten Stromkreises oder zumindest von Teilen davon, und
- Fig. 23: das elektrische Schaltungsdiagramm einer Energieversorgungsanordnung für ein Schienenfahrzeug, wobei die Anordnung an ein Energieversorgungsnetz und an einen Gleichspannungszwischenkreis mit einem daran angeschlossenen Traktionsstromrichter angeschlossen ist.

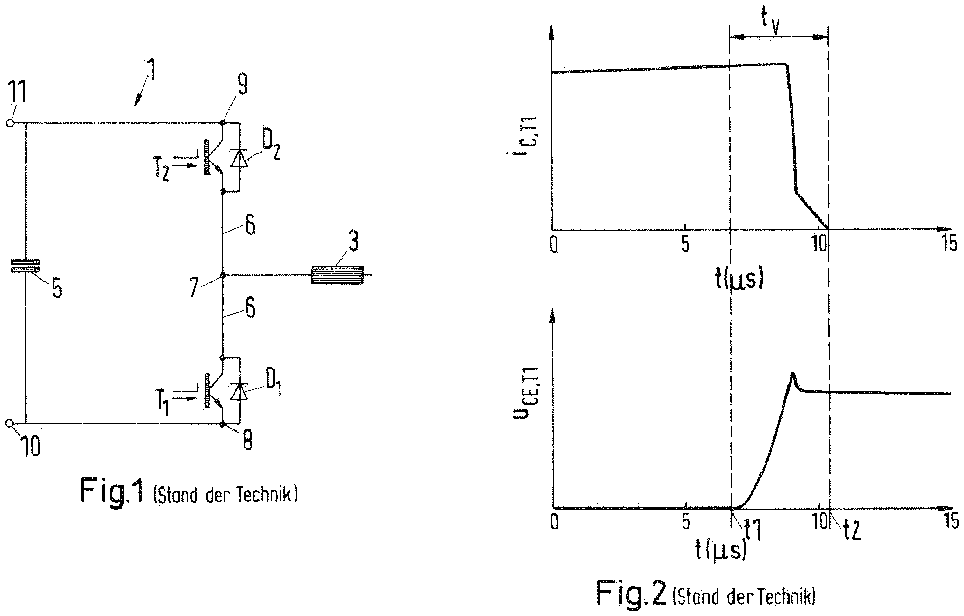

Fig. 1 zeigt eine Schaltungsanordnung 1 gemäß dem Stand der Technik. Ein erster elektronischer Schalter T₁ und ein zweiter elektronischer Schalter T₂ sind über eine elektrische Leitungsverbindung 6 miteinander in Reihe geschaltet. Die Anschlüsse 8, 9 an den entgegengesetzten Enden der Reihenschaltung sind mit elektrischen Anschlüssen 10 bzw. 11 der Schaltungsanordnung verbunden, an die beim Betrieb der Schaltungsanordnung 1 eine Gleichspannung angelegt wird. Zur Glättung etwaiger Gleichspannungsschwankungen ist ein Kondensator 5 zwischen die Anschlüsse 10, 11 geschaltet.

Eine erste Induktivität 3 ist mit dem Anschlusspunkt 7 der Leitungsverbindung 6 zwischen dem ersten elektronischen Schalter T₁ und dem zweiten elektronischen Schalter T₂ verbunden. Ferner ist den elektronischen Schaltern T jeweils eine Freilaufdiode D₁, D₂ antiparallel geschaltet.

Anders als in Fig. 1 dargestellt (und auch anders als in der ähnlichen Fig. 3 dargestellt) kann der zweite elektronische Schalter T₂ entfallen. Es verbleibt lediglich die Freilaufdiode D₂.

Während des Betriebs der Schaltungsanordnung 1 werden die elektronischen Schalter T abwechselnd eingeschaltet, d.h. vor dem Einschalten des jeweils anderen elektronischen Schalters T wird der Schalter ausgeschaltet. Es besteht eine Wartezeit Δt zwischen dem Ausschalten des einen Schalters und dem Einschalten des anderen Schalters, damit kein Kurzschluss zwischen den Anschlüssen 10, 11 gebildet wird.

In vielen Fällen ist die Induktivität 3 groß, sodass zum Zeitpunkt des Ausscheidens des jeweiligen Schalters T der durch den Schalter T fließende Strom zunächst aufrechterhalten bleibt. Dieser Fall liegt in der großen Mehrzahl der Anwendungen, in denen IGBTs als Schalter eingesetzt werden, vor und wird als "hartes Schalten" bezeichnet. Während nach dem Ausschalten die Kollektor-Emitter-Spannung ansteigt, fließt weiter ein Strom durch den IGBT. Erst wenn eine Mindestspannung erreicht ist, kann die Inversdiode (Freilaufdiode) des anderen Schalters den Strom übernehmen und der Strom durch den abgeschalteten Schalter nimmt ab, während die Spannung, die über den abgeschalteten Schalter abfällt, bereits einen stationären, hohen Wert erreicht hat.

Wenn die Schaltungsanordnung 1 in dieser Weise betrieben wird, zeigen am Beispiel eines Schaltvorgangs des ersten elektronischen Schalter T₁ der elektrische Strom i_{C,T1} sowie die elektrische Spannung u_{CE, T1}, die über den ersten elektronischen Schalter T₁ abfällt, den in Fig. 2 dargestellten Verlauf. Im oberen Teil der Fig. 2 ist der zeitliche Verlauf des Stroms i_{C, T1} durch den ersten elektronischen Schalter T₁ dargestellt. Im unteren Teil der Fig. 2 ist der Verlauf der Spannung u_{CE, T1} dargestellt. Zu Beginn des in Fig. 2 dargestellten Zeitbereichs befindet sich der erste elektronische Schalter T₁ in seinem eingeschalteten Zustand. Zum Zeitpunkt t1 wird der erste Schalter T₁ ausgeschaltet. Die elektrische Spannung u_{CE, T1} steigt an und die erste Induktivität 3 hält den Strom durch den ersten Schalter T₁ zunächst aufrecht, bis er abfällt und die Spannung wieder leicht zurückgeht. Danach fällt der Strom langsamer ab, bis er zum Zeitpunkt t2 den Wert Null erreicht. Während des Zeitintervalls t_{V} zwischen den Zeitpunkten t1 und t2 treten erhebliche Schaltverluste auf, da während des Anliegens einer elektrischen Spannung an dem ersten Schalter ein zunächst sogar noch unverändert hoher Strom durch diesen fließt. Die Verlustleistung berechnet sich aus dem Produkt der Spannung und dem Strom. Durch Integration über die Zeit wird die Verlustenergie berechnet. Das vorangegangene Beispiel betrifft einen einzelnen Schaltvorgang. Später, bei der Beschreibung erfindungsgemäßer Ausgestaltungen, wird auf periodisch wiederkehrende Schaltvorgänge insbesondere im Mittelfrequenzbereich eingegangen.

Die in Fig. 3 dargestellte Schaltungsanordnung unterscheidet sich von der in Fig. 1 dargestellten Schaltungsanordnung lediglich dadurch, dass die erste Induktivität 3 durch ein externes Netzwerk als Serienresonanzkreis mit einer Kapazität 2a und einer Induktivität 2b ersetzt ist.

Im Gegensatz zu Fig. 1 werden die IGBTs T₁ und T₂ nicht mehr hart schaltend betrieben. Über das externe Netzwerk 2 wird sichergestellt, dass zu einem bestimmten Zeitpunkt während des Betriebes der Schaltungsanordnung der Strom durch den abzuschaltenden IGBT null oder nahezu null ist. In Fig. 4 sind ähnlich zu Fig. 2 der Strom durch den Schalter T₁ und die über den Schalter abfallende Spannung dargestellt. Zum Zeitpunkt t = 7 µs verschwindet der Strom und der Schalter T₁ erhält zu diesem Zeitpunkt ein Ausschaltsignal, d.h. seine Gate-Emitter-Spannung wird unter die Einschaltschwelle gesenkt, typischerweise auf -15...0 V. Da zu diesem Zeitpunkt kein Strom durch den IGBT fließt, tritt kein hartes Schalten auf. Allerdings baut sich zu diesem Zeitpunkt auch noch keine Kollektor-Emitter-Spannung auf, da der IGBT direkt nachdem er den Ausschaltbefehl erhalten hat noch mit Ladungsträgern überschwemmt ist, die einen leitfähigen Kanal zwischen Kollektor- und Emitter-Anschluss bilden. Dies stellt einen Unterschied bipolarer Halbleiterschalter zu anderen Halbleiterschaltern dar, z.B. MOSFETs, bei denen nach Erhalten des Ausschaltbefehls, d.h. nachdem die Gate-Source-Spannung auf Werte unterhalb der Einschaltschwelle gesenkt ist, keine freien Ladungsträger mehr vorhanden sind, die einen leitfähigen Kanal bilden könnten. Wird nun jedoch der zweite Schalter T₂ eingeschaltet, können die freien Ladungsträger aus dem ersten Schalter T₁ abfließen und es baut sich eine Spannung U_{CE,T1} über dem ersten Schalter T₁ auf. Dieser Vorgang ist jedoch im Verlust-Zeitintervall T_{V} zwischen den Zeitpunkten t3 und t4 auch verlustbehaftet, da ein elektrischer Strom aus dem den ersten Schalter fließt, während sich die Spannung über dem Schalter aufbaut. Jedoch sind die Verluste kleiner als im Falle des harten Schaltens.

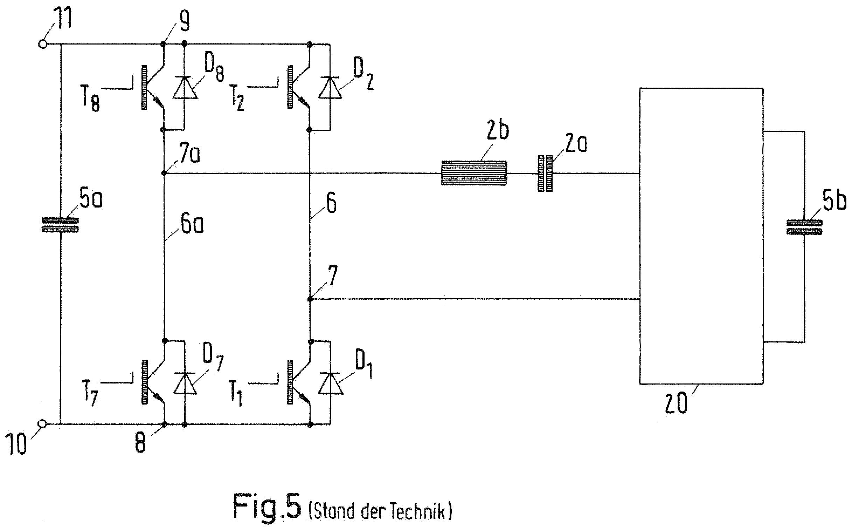

Fig. 5 zeigt eine mögliche Ausführung der abstrahiert dargestellten Schaltungsanordnung aus Fig. 3. Es ist ein Serienresonanzkonverter dargestellt, bei dem Energie von der ersten Kapazität 5a (links in der Figur) zu einer zweiten Kapazität 5b (rechts in der Figur) transferiert wird. Links ist eine Vollbrückenschaltung dargestellt, bei der der Anschlusspunkt 7a zwischen dem Schalter T₇ und dem Schalter T₈ über das Netzwerk 2 mit einem aktiven Gleichrichter 20 verbunden ist. Ferner ist der Anschlusspunkt 7 zwischen dem ersten Schalter T₁ und dem zweiten Schalter T₂ direkt mit einem zweiten Anschluss des Gleichrichters 20 verbunden. Die zweite Kapazität 5b an der Gleichspannungsseite des Gleichrichters 20 angeschlossen. Der Gleichrichter 20 kann auch als aktiver Gleichrichter ausgeführt sein, wodurch es möglich ist Energie von der zweiten (5b) zur ersten (5a) Kapazität zu transferieren.

Die in Fig. 6 dargestellte Schaltungsanordnung unterscheidet sich von der in Fig. 5 dargestellten durch eine zusätzliche Induktivität 3, die zwischen die Anschlusspunkte 7, 7a der Vollbrücke geschaltet ist. Die Schaltungsanordnung stellt wiederum einen Serienresonanzkonverter dar. Durch die zusätzliche Induktivität fließt ein Blindstrom, der nach dem Ausschalten eines IGBT-Paares der Vollbrücke, deren Schalter in Reihe geschaltet sind, freie Ladungsträger aus dem zuletzt abgeschalteten Schalter des Paares ausräumt. Damit verringert sich der während der Zeit T_{V} in Fig. 4 fließende Strom i_{C,T1}. Obwohl der zusätzliche Blindstrom zusätzliche Verluste hervorruft, werden durch diesen Effekt die Gesamtverluste gesenkt. Das Hinzufügen dieser Induktivität 3 entspricht dem Stand der Technik und wird z.B. in der Veröffentlichung "High voltage IGBTs and medium frequency transformer in DC-DC converters for railway applications" von Weigel, J., Nagel, A. und Hoffmann, H., veröffentlicht auf der Konferenz 2010 International Symposium on Power Electronics Electrical Drives Automation and Motion (SPEEDAM), beschrieben. Dabei entspricht die Induktivität 3 der in der Veröffentlichung in Fig. 5 gezeigten Induktivität L_{adj}.

Nachteilig an dieser Lösung ist jedoch, dass der eingestellte Strom durch die Induktivität 3 während des Betriebes nicht angepasst werden kann und somit nur für einen Betriebspunkt optimal ausgelegt werden kann. Wird die Induktivität 3 zu groß gewählt und der Strom durch die Induktivität 3 damit zu klein gewählt, tritt - zwar in verringertem Maße - weiterhin ein Verhalten wie in Fig. 4 gezeigt auf. Wird die Induktivität 3 zu klein gewählt und der Strom durch die Induktivität 3 damit zu groß gewählt tritt hartes Schalten auf, entsprechend dem in Fig. 2 dargestellten Verhalten, auch wenn der Strom zum Zeitpunkt des Ausschaltens des Schalters deutlich kleiner als in Fig. 2 wäre.

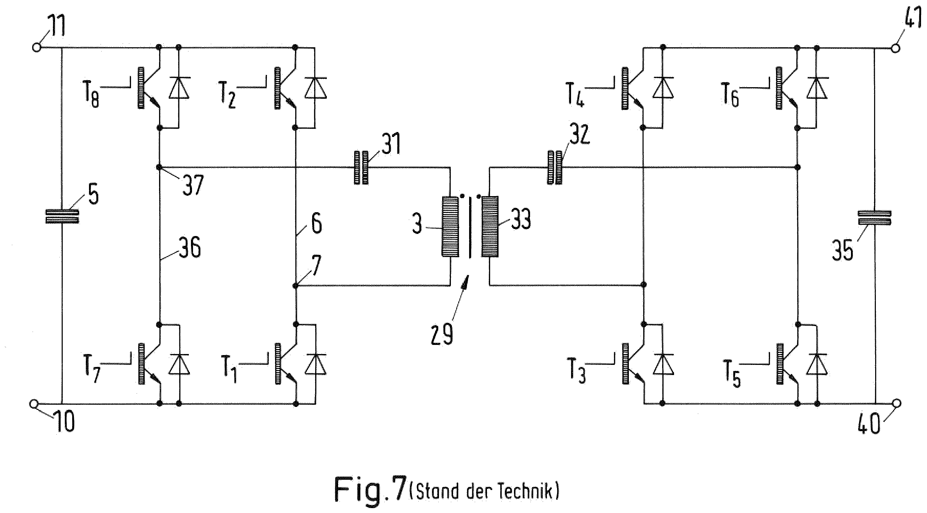

Fig. 7 zeigt eine Schaltungsanordnung, bei der es sich um einen Serienresonanzkonverter, nämlich einen DC/DC-Konverter handelt. Auf der Primärseite und der Sekundärseite des Transformators 29 ist jeweils eine Vollbrücke mit zwei parallelen Brückenzweigen vorhanden, wobei jeder Brückenzweig eine Serienschaltung aus zwei elektronischen Schaltern T aufweist. Wiederum sind gleiche Elemente mit gleichen Bezugszeichen wie in den vorangegangenen Figuren bezeichnet.

Auf der Primärseite des Transformators 29 ist ein Kondensator 31 in Reihe zu der ersten Induktivität 3 des Transformators geschaltet und auf der Sekundärseite des Transformators 29 ist ein Kondensator 32 in Reihe zu der Induktivität 33 geschaltet. In dem Betriebszustand, vor dem Zeitraums des Abschaltens des ersten Schalters T₁, ist nicht nur der erste elektronische Schalter T₁, sondern auch der entsprechende weitere elektronische Schalter T₈ des zweiten Brückenzweiges auf der Primärseite des Transformators 29 eingeschaltet. Der Strom fließt in diesem Fall von dem Anschluss 11 über den weiteren elektronischen Schalter T₈, den Anschlusspunkt 37, den Kondensator 31 von oben nach unten durch die erste Induktivität 3, den Anschlusspunkt 7 und den ersten elektronischen Schalter T₁ zu dem Anschluss 10. Nach dem Abschalten dieser beiden Schalter T₁ und T₈ und vor dem Einschalten der Schalter T₂ und T₇ verbleiben freie Ladungsträger sowohl in dem ersten elektronischen Schalter T₁ als auch in dem weiteren elektronischen Schalter T₈, die wie oben anhand beschrieben zu Schaltverlusten führen.

In der Schaltungsanordnung in Fig. 7 ist entspricht die Streuinduktivität des Transformators (gebildet durch die Elemente 3, 29 und 33) der Induktivität 2b der Resonanzkreise aus den vorhergehenden Fig. 6, 5 und 3. Die Hauptfeldinduktivität des Transformators entspricht dabei der in den vorangegangenen Figuren dargestellten Induktivität 3. Diese Ausführung hat neben dem Vorteil der Integration der Bauelemente den weiteren Vorteil der Potentialtrennung. Dargestellt ist eine bidirektionale Variante, bei der Energie sowohl von Kondensator 5 nach Kondensator 35 als auch von Kondensator 32 nach Kondensator 31 fließen kann.

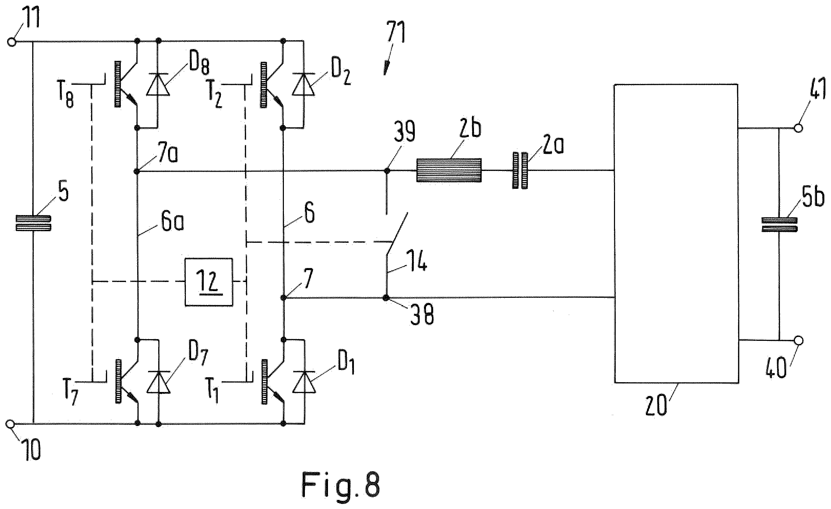

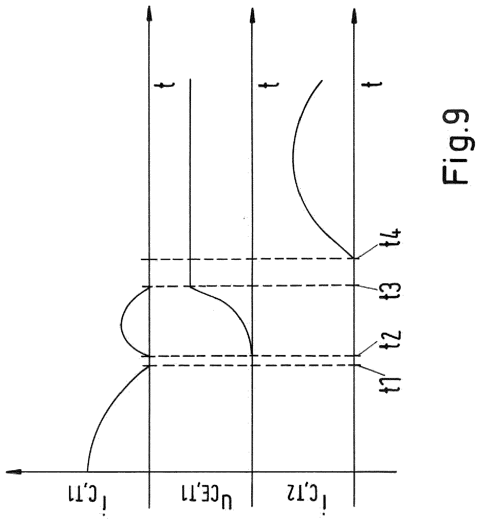

Fig. 8 zeigt eine Schaltungsanordnung 71 ähnlich der in Fig. 5, wobei jedoch ein zusätzlicher zweiter Stromkreis 14 vorgesehen, der einen Zusatzschalter 15 aufweist. Der Betrieb dieser Anordnung wird im Folgenden anhand von Fig. 9 erläutert, die den zeitlichen Verlauf der elektrischen Größen vereinfacht darstellt. Dabei sind für ein Ausführungsbeispiel des Betriebes der Schaltungsanordnung die zeitlichen Verläufe der elektrischen Ströme i_{C,T1} und i_{C,T2} durch die Schalter T₁, T₂ und die über den ersten Schalter T₁ abfallende elektrische Kollektor-Emitter Spannung u_{CE,T1} dargestellt, jedoch schematisch. Insbesondere kann der Verlauf des Stroms i_{C, T1} zwischen den Zeitpunkten t1 und t2 unterschiedliche, nicht dargestellte zeitliche Verläufe zeigen. Da in der gezeigten Anordnung T₈ entsprechend synchron mit T₁ und T₇ synchron mit T₂ geschaltet wird gelten die Ausführungen entsprechend auch für diese Schalter. Insbesondere werden daher Ladungsträger auch gleichzeitig aus den synchron abgeschalteten Schaltern ausgeräumt. Der Einfachheit halber wird an dieser Stelle jedoch nur von T₁ und T₂ gesprochen.

Insbesondere kann die Figur periodische Schaltvorgänge im Mittelfrequenzbereich betreffen, weshalb die Wartezeit für das Einschalten von in Reihe geschalteten Schaltern entsprechend kurz ist. Andererseits wiederholt sich der Vorgang in diesem Fall mehrere hundert bis einige zehntausend Male während einer Sekunde, so dass die Verlustleistung entsprechend groß wäre, wenn die Ladungsträger nicht in der erfindungsgemäßen Weise aus den abgeschalteten Schalter ausgeräumt werden.

Nach dem Ausschalten des ersten elektronischen Schalters T₁ zum Zeitpunkt t1, wenn auch die sinusförmige Halbwelle des Stroms i_{C, T1} durch den ersten elektronischen Schalter T₁ null ist, wird zu einem Zeitpunkt t2 der Zusatzschalter 15 eingeschaltet, d.h. der zweite Stromkreis 14 geschlossen. Dadurch beginnt ein Strom durch den Schalter 14 zu fließen. Der Strom fließt durch den ersten elektronischen Schalter T₁ und räumt die verbliebenen freien Ladungsträger aus bzw. lässt diese rekombinieren. Die Rekombination wird nicht nur in diesem Ausführungsbeispiel als Variante des Ausräumens von Ladungsträger verstanden. Vorzugsweise sind Realisierungen des Zusatzschalters 15 (insbesondere eine zusätzliche kleine Induktivität in Serie mit dem Schalter) und die Einschaltdauer des Zusatzschalters 15 zwischen den Zeitpunkten t2 und t3 so gewählt, dass bei allen möglichen Betriebszuständen während des Betriebs der Schaltungsanordnung, d.h. insbesondere bei unterschiedlicher Stärke des Stromes durch den ersten Schalter T₁, die in dem ersten elektronischen Schalter T₁ verbliebenen freien Ladungsträger vollständig ausgeräumt werden. Dabei ist auch zu berücksichtigen, dass es sich bei der dargestellten Schaltungsanordnung um eine besonders einfache Schaltungsanordnung handelt, die stellvertretend für abgewandelte Schaltungsanordnungen stehen. Ausführungsbeispiele dieser abgewandelten Schaltungsanordnungen werden im Folgenden noch beschrieben.

Gemeinsame Elemente dieser Schaltungsanordnungen sind die Schalter T₁ und T₂, wobei wie schon ausgeführt einer der Schalter durch eine Diode ersetzt werden kann. Ferner ist der Zusatzschalter entweder elektrisch und/oder magnetisch mit dem Schalter T₁ und T₂ verbunden/gekoppelt. Außerdem sind gemeinsame Elemente einiger dieser Schaltungsanordnungen die erste Induktivität, welche bei eingeschaltetem erstem elektronischem Schalter von Strom durchflossen wird, wenn eine entsprechende Spannung anliegt. Ferner ist die erste Induktivität im Fall ihres Vorhandenseins mit der elektrischen Verbindung (Anschlusspunkt 7) der beiden in Reihe geschalteten elektronischen Schalter verbunden. Der andere Anschluss der ersten Induktivität kann jedoch verschieden ausgeführt sein. Zum Beispiel kann die erste Induktivität Teil eines Netzwerkes sein wie in Fig. 5, zwischen die Anschlüsse der beiden Reihenschaltungen von elektronischen Schaltern wie in Fig. 7 geschaltet sein oder wie in Fig. 8 ausgeführt sein Ferner können zusätzliche, nicht in Fig. 8 und den folgenden Figuren dargestellte Schaltungselemente vorhanden sein, z.B. zusätzliche Kondensatoren oder Widerstände.

Beim Betrieb der in Fig. 8 dargestellten Schaltungsanordnung wird gemäß den zeitlichen Verläufen, die in Fig. 9 dargestellt sind, nach dem Ausschalten des ersten Schalters T₁ (Zeitpunkt t1) zum Zeitpunkt t2 der Zusatzschalter 15 eingeschaltet. Es beginnt ein Strom durch den Zusatzschalter 15 zu fließen, der auch durch den ersten Schalter T₁ fließt und der hier schematisch als sinusförmig dargestellt ist. Mit diesem Strom werden die im Basisgebiet des ersten Schalters T₁ noch vorhandenen Ladungsträger ausgeräumt. Dadurch beginnt der erste Schalter T₁ zu sperren und die über den ersten Schalter T₁ abfallende Spannung U_{CE, T1} beginnt zu steigen. Sobald die Ladungsträger in dem ersten Schalter T₁ vollständig ausgeräumt sind und die maximal mögliche Spannung U_{CE, T1} über den ersten Schalter T₁ abfällt, endet der Stromfluss sowohl durch den ersten Schalter T₁ als auch durch den Zusatzschalter 15. Im Vergleich zu den in Fig. 2 und 4 dargestellten Betriebsweisen ist die Verlustleistung nach dem Ausschalten des ersten Schalters T₁ erheblich reduziert.

Alternativ kann der Zusatzschalter 15 unmittelbar vor, gleichzeitig oder nach dem Ausschalten des ersten Paars von Hauptschalters (z. B. T₁ und T₈ oder T₂ und T₇ wird der zweite Stromkreis 14 gebildet, durch den nun ein elektrischer Strom fließen kann, der die verbliebenen Ladungsträger in den Hauptschaltern (z. B. IGBTs oder andere bipolare Schalter) ausräumt.

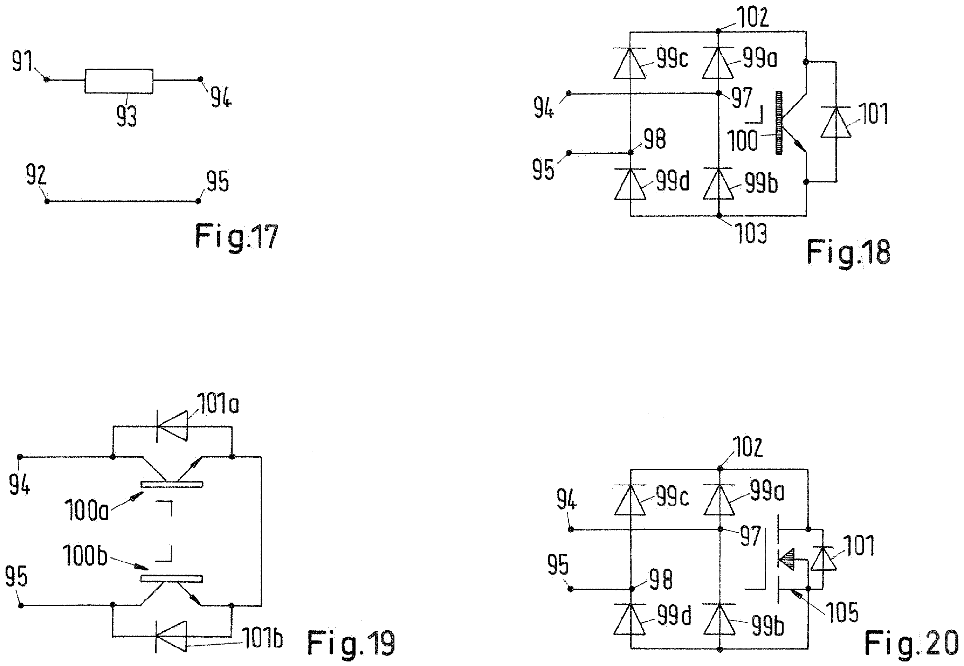

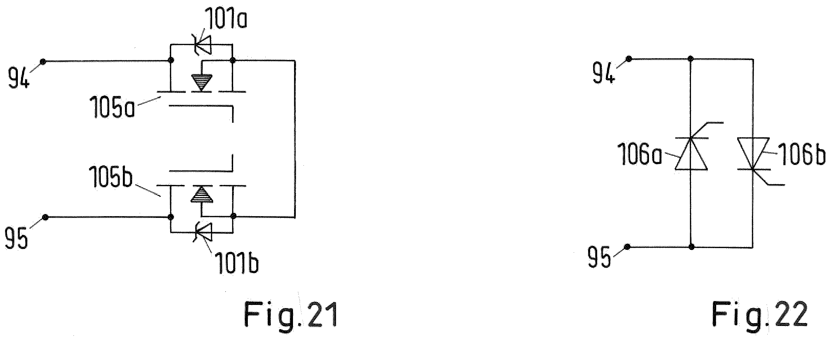

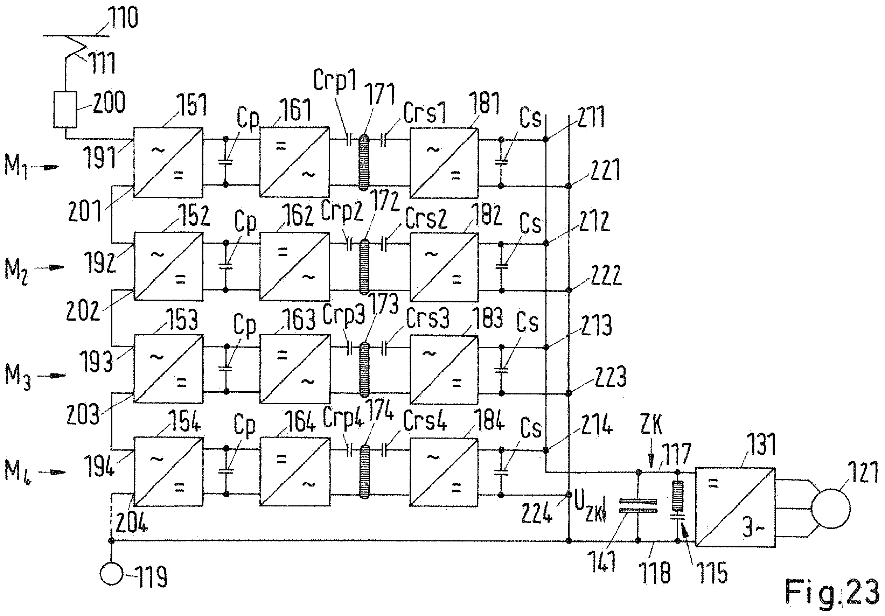

Auf Ausführungsbeispiele des Schalters 15 wird noch näher eingegangen. Insbesondere ist es vorteilhaft diesem Zusatzschalter 15 ein elektrisches Element, zum Beispiel einen Widerstand oder eine Induktivität, in Serie zu schalten. Insbesondere kann der Zusatzschalter je nach Ausführung bereits eine kurze Zeitdauer (z. B. bis zu einige Mikrosekunden) vor Ausschalten der Hauptschalters (zum Beispiel T₁ und T₈) eingeschaltet werden. Wiederum je nach Ausführung des Zusatzschalters muss dieser unter Umständen ausgeschaltet werden, bevor das andere Paar von Hauptschalter (zum Beispiel T₂ und T₇) eingeschaltet wird. Bei einer Variante des Zusatzschalters entsprechend Fig. 19 oder 21 ist das Ausschalten erforderlich, bei einer Variante nach Fig. 20 oder 22 ist es nicht erforderlich und bei einer Variante nach Fig. 23 sogar nicht möglich (hier verlöschen die eingesetzten Thyristoren bei Einschalten des Hauptschalters des anderen Paares von selbst). Vorteilhaft ist, dass nur so lange Strom fließt wie freie Ladungsträger vorhanden sind - d.h. im Gegensatz zu einer Lösung mit Induktivität 3 entsprechend Fig. 6 stellt sich der Strom entsprechend der Last ein, so dass die erwähnten Nachteile der Lösung von Fig. 6 entfallen. Mit dem Bezugszeichen 12 ist eine Steuerung bezeichnet, die über gestrichelt dargestellte Steuerleitungen mit den elektronischen Schaltern T und dem Zusatzschalter 15 verbunden ist, um die Schalter ein- und auszuschalten. Die Steuerung 12 enthält insbesondere die übergeordnete Steuereinheit, welche die Schaltvorgänge der verschiedenen Schalter miteinander zeitlich koordiniert. Sie kann aber optional auch die Einheiten enthalten, welche die Aufladung und Entladung der Steuerelektroden der Schalter steuert.

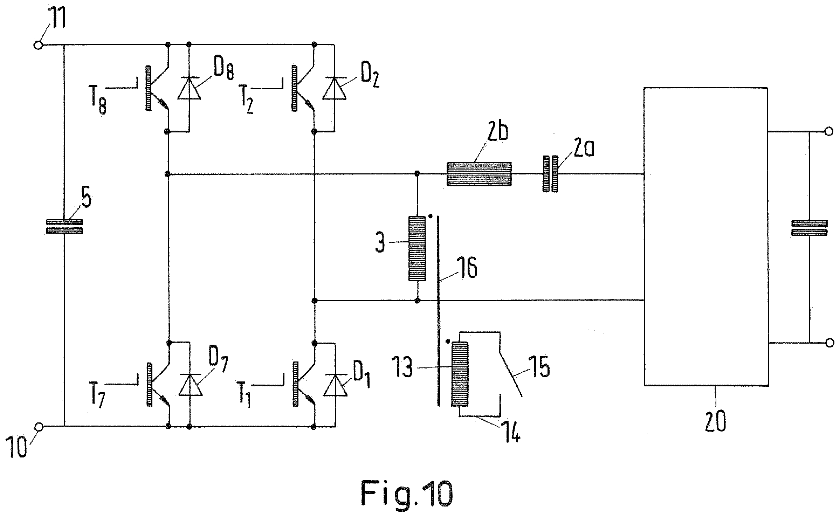

Fig. 10 zeigt eine weitere erfindungsgemäße Ausführung eines Serienresonanzkonverters. Der Zusatzschalter 15 weist einen Transformator auf mit magnetischem Flussführungsteil 16, einer ersten Induktivität 3 und einer zweiten Induktivität 13, die magnetisch mit der ersten Induktivität 3 gekoppelt ist. Gegenüber der Lösung aus Fig. 8 besteht der Vorteil darin, dass bei entsprechend gewähltem Übersetzungsverhältnis (die zweite Induktivität 13 weist weniger Windungen auf als die erste Induktivität drei) des Transformators die benötigte Sperrspannung des Zusatzschalters 15 kleiner gewählt kann. Dies gilt auch bei anderen Ausführungsformen als in Fig. 10 gezeigt. Zusätzlich kann die Streuinduktivität des Transformators als strombegrenzendes Element genutzt werden.

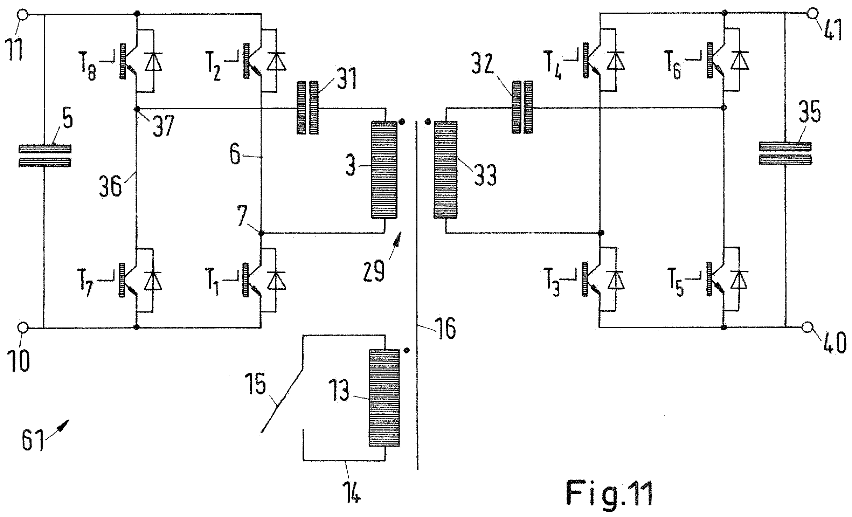

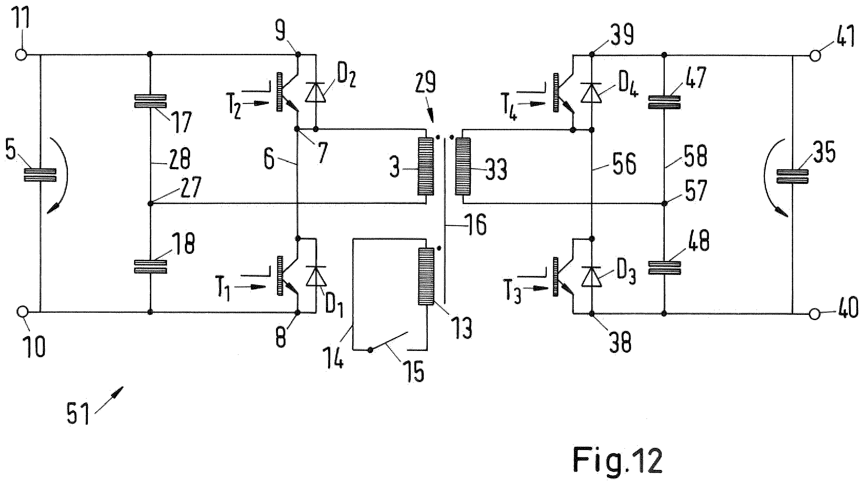

Fig. 11 zeigt eine Schaltungsanordnung 61, bei der es sich wiederum um einen DC/DC-Konverter handelt. Im Unterschied zu der Schaltungsanordnung in den folgenden Figuren 12 - 14 ist jedoch auf der Primärseite und der Sekundärseite des Transformators 29 jeweils eine Vollbrücke mit zwei parallelen Brückenzweigen vorhanden, wobei jeder Brückenzweig eine Serienschaltung aus zwei elektronischen Schaltern T aufweist. Wiederum sind gleiche Elemente mit gleichen Bezugszeichen wie in den vorangegangenen Figuren bezeichnet.

Bei dem Konverter 61 handelt es sich um einen Serienresonanzkonverter, bei dem auf der Primärseite des Transformators 29 ein Kondensator 31 in Reihe zu der ersten Induktivität 3 geschaltet ist und bei dem auf der Sekundärseite des Transformators 29 ein Kondensator 32 in Reihe zu der Induktivität 33 geschaltet ist. In einem Betriebszustand z. B. vor dem Abschalten des ersten elektronischen Schalters T₁ ist auch der entsprechende weitere elektronische Schalter T₈ des zweiten Brückenzweiges auf der Primärseite des Transformators 29 eingeschaltet. Der Strom fließt in diesem Fall von dem Anschluss 11 über den weiteren elektronischen Schalter T₈, den Anschlusspunkt 37, den Kondensator 31 von oben nach unten (in der Darstellung der Fig. 11) durch die erste Induktivität 3, den Anschlusspunkt 7 und den ersten elektronischen Schalter T₁ zu dem Anschluss 10. Nach dem Abschalten dieser beiden Schalter T₁ und T₈ und vor dem Einschalten der Schalter T₂ und T₇ fließt nach dem Einschalten des Zusatzschalters 15 ein Strom durch den zweiten Stromkreis 14 und daher auch ein Ausräumstrom durch die erste Induktivität 3, welcher verbliebene freie Ladungsträger sowohl in den ersten elektronischen Schalter T₁ als auch in den entsprechenden weiteren elektronischen Schalter T₈ ausräumt.

Fig. 12 zeigt einen DC/DC-Konverter 51. Soweit gleiche Elemente wie in den vorangegangenen Figuren vorhanden sind, werden gleiche Bezugszeichen benutzt. So ist z.B. zwischen die Gleichspannungsanschlüsse 10, 11 der Schaltungsanordnung ebenfalls ein Glättungskondensator 5 geschaltet und ist die Reihenschaltung des ersten elektronischen Schalters T₁ und des zweiten elektronischen Schalters T₂ an den entgegengesetzten Enden über den Anschluss 8 an dem einen Ende mit dem Anschluss 10 und über den Anschluss 9 an dem anderen Ende mit dem Anschluss 11 verbunden. Parallel zu der Reihenschaltung der elektronischen Schalter T₁, T₂ ist eine Reihenschaltung mit Kondensatoren 17, 18 geschaltet. Die erste Induktivität 3 ist an ihrem einen Anschluss mit der elektrischen Verbindung 6 zwischen den elektronischen Schaltern T und mit ihrem anderen Anschluss über einen Anschlusspunkt 27 mit einer elektrischen Verbindung 28 zwischen den beiden Kondensatoren 17, 18 verbunden.

Ferner ist bei der Schaltungsanordnung 51 die erste Induktivität 3 als Induktivität auf der Primärseite eines Transformators 29 ausgestaltet. Die Induktivität 33 auf der Sekundärseite des Transformators 29 ist über denselben magnetischen Kern 16, der auch die erste Induktivität 3 und die zweite Induktivität 13 miteinander koppelt, magnetisch angekoppelt. Alternativ könnte jedoch für die Kopplungen zwischen der ersten Induktivität 3 und der Sekundärseite des Transformators 29 einerseits und zwischen der ersten Induktivität 3 und der zweiten Induktivität 13 andererseits eine zumindest teilweise verschiedene Kopplung genutzt werden, z.B. ein separater Kern oder ein Fortsatz des Kerns der anderen magnetischen Kopplung.

Die Induktivität 33 ist spiegelbildlich zu der Schaltung auf der Primärseite des Transformators 29 an eine spiegelbildlich aufgebaute Schaltungsanordnung angeschlossen. Anders ausgedrückt befindet sich für jedes Element der Teil-Schaltungsanordnung auf der Primärseite des Transformators 29 ein entsprechendes Element und entsprechend verschaltetes Element auf der Sekundärseite des Transformators 29. Daher ist ebenfalls auf der Sekundärseite eine Reihenschaltung von zwei elektronischen Schaltern T₃, T₄ mit antiparallel geschalteten Freilaufdioden D₃, D₄ vorhanden, wobei dieser Reihenschaltung eine Reihenschaltung von zwei Kondensatoren 47, 48 parallel geschaltet ist, die über eine elektrische Verbindung 58 miteinander verbunden sind. Der eine Anschluss der Induktivität 33 ist mit dieser elektrischen Verbindung 58 verbunden, der andere mit der elektrischen Verbindung 56 zwischen den beiden elektronischen Schaltern T₃, T₄. An den Gleichspannungsanschlüssen 40, 41 der Sekundärseite kann eine Gleichspannung abgegriffen werden bzw. ein Stromkreis für einen Gleichstrom angeschlossen werden.

Da der zweite Stromkreis 14 mit dem Zusatzschalter 15 und der zweiten Induktivität 13 entweder direkt oder indirekt sowohl mit der ersten Induktivität 3 als auch mit der Induktivität 33 auf der Sekundärseite des Transformators 29 gekoppelt ist, ist zumindest grundsätzlich nur ein solcher zusätzlicher Stromkreis 14 erforderlich, selbst wenn der Stromkreis 14 auch für das Ausräumen von verbliebenen Ladungsträgern aus zumindest einem der elektronischen Schalter T₃, T₄ genutzt werden soll. Dies ist beispielsweise dann der Fall, wenn elektrische Energie von der Sekundärseite des Transformators 29 auf dessen Primärseite übertragen werden soll.

Anders als in Fig. 12 bis Fig. 14 dargestellt, kann der Glättungskondensator 5 entfallen, da für denselben Zweck auch die Reihenschaltung der Kondensatoren 17, 18 eingesetzt werden kann. Entsprechendes gilt für die Sekundärseite des Transformators 29.

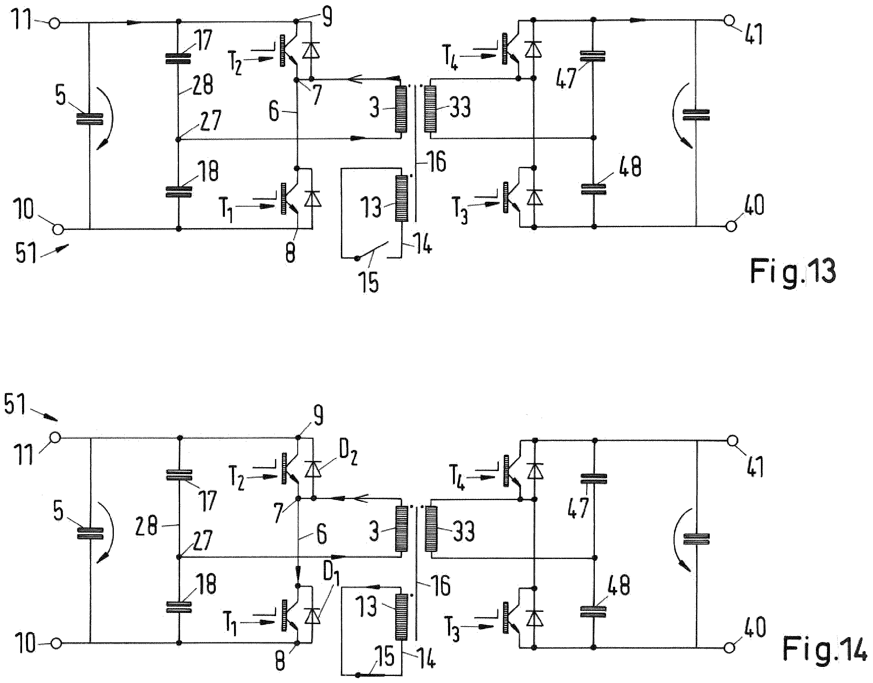

Zwei Betriebszustände der Schaltungsanordnung aus Fig. 12 werden nun anhand von Fig. 13 und Fig. 14 beschrieben. In dem in Fig. 13 dargestellten Betriebszustand ist der erste elektronische Schalter T₁ eingeschaltet.

Der Stromfluss führt von dem Anschluss 11 über den Kondensator 17, den Anschlusspunkt 27, den unteren Anschluss der ersten Induktivität 3, dem oberen Anschluss der Induktivität 3, dem Anschlusspunkt 7 durch den ersten elektronischen Schalter T₁ und den Anschlusspunkt 8 zu dem Anschluss 10. Dabei ist der Zusatzschalter 15 ausgeschaltet, d.h. es kann kein Stromfluss durch die zweite Induktivität 13 stattfinden.

Nach dem Ausschalten des ersten elektronischen Schalters T₁ und nach dem Einschalten des Zusatzschalters 15 ergibt sich der in Fig. 14 dargestellte Betriebszustand. Es findet ein Stromfluss durch den zweiten Stromkreis 14 und damit durch die zweite Induktivität 13 statt. Aufgrund des Anwachsens dieses Stroms wird über die magnetische Kopplung 16 ein Strom durch die erste Induktivität 3 induziert, so dass der Ausräumstrom zum Ausräumen der Ladungsträger durch die Induktivität 3 und den ersten elektronischen Schalter T₁ fließt.

Die Zusatzschaltung mit dem zweiten Stromkreis 14, der zweiten Induktivität 13 und dem Zusatzschalter 15 kann bei entsprechender Ausgestaltung (darauf wird noch anhand von Fig. 17 bis Fig. 22 eingegangen) auch zum Ausräumen verbliebener Ladungsträger nach dem Ausschalten des zweiten elektronischen Schalters T₂ genutzt werden. Während der zweite elektronische Schalter T₂ eingeschaltet ist, fließt ein Strom von dem Anschluss 11 über den Anschlusspunkt 9 durch den zweiten elektronischen Schalter T₂ zu dem Anschlusspunkt 7 und von dort durch den oberen Anschluss der ersten Induktivität 3, durch diese hindurch zu dem Anschlusspunkt 27, dem Kondensator 18 und zu dem Anschluss 10. Somit ist die Stromrichtung durch die erste Induktivität 3 entgegengesetzt im Vergleich zu dem in Fig. 13 dargestellten Fall. Währenddessen ist der Zusatzschalter 15 geöffnet. Nach dem Ausschalten des zweiten elektronischen Schalters T₂, wenn der Zusatzschalter 15 geschlossen ist, fließt ein Ausräumstrom zum Ausräumen der verbliebenen Ladungsträger in dem zweiten elektronischen Schalter T₂ ebenfalls von dem Anschlusspunkt 9 zu dem Anschlusspunkt 7 und von dort zu dem oberen Anschluss der ersten Induktivität 3 und durch diese hindurch. Diese Stromrichtung ist somit der in Fig. 14 durch Pfeile dargestellten Stromrichtung entgegengesetzt. Da die magnetische Kopplung 16 die Induktivitäten 3, 13 bezüglich der Wechselwirkung von magnetischem Fluss und elektrischer Spannung in den Induktivitäten eindeutig miteinander verknüpft, muss der Stromfluss durch die zweite Induktivität 13 beim Ausräumen der verbliebenen Ladungsträger in dem zweiten elektronischen Schalter T₂ ebenfalls in umgekehrter Richtung verlaufen.

Vorzugsweise werden die DC/DC-Konverter gemäß Fig. 11 bis Fig. 14 sowie jede andere Schaltungsanordnung, bei der ein zweiter elektronischer Schalter in Reihe zu dem ersten elektronischen Schalter angeordnet ist, wechselweise betrieben, d.h. beide Schalter werden abwechselnd und z.B. bei derselben Schaltfrequenz ein- und ausgeschaltet. Bevorzugtermaßen wird dabei nach jedem Ausschalten eines der elektronischen Schalter der Zusatzschalter in dem zweiten Stromkreis oder ein Zusatzschalter in einem der zusätzlichen Stromkreise eingeschaltet, um die verbliebenen Ladungsträger in dem zuvor ausgeschalteten elektronischen Schalter auszuräumen.

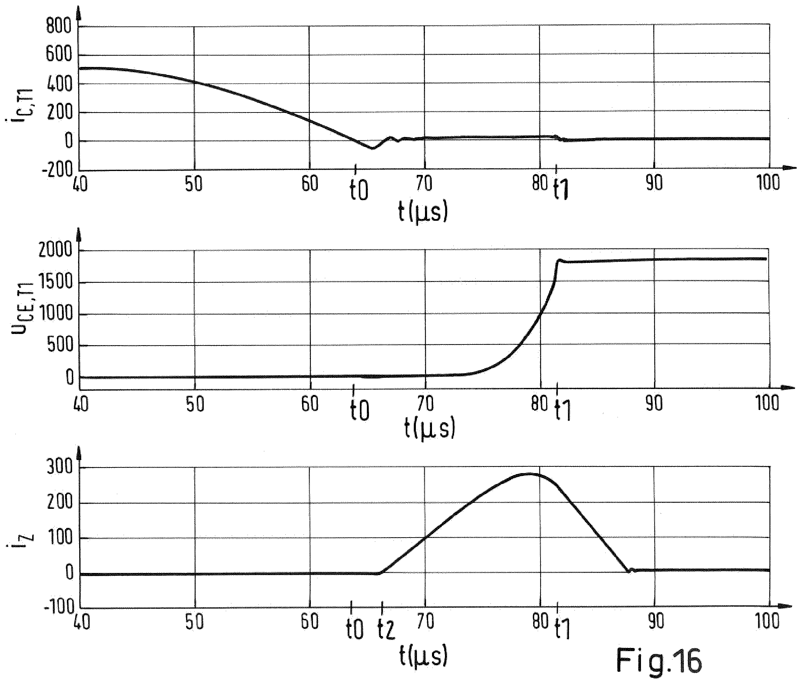

Wenn bei der Schaltungsanordnung in Fig. 12 der Zusatzschalter 15 dauerhaft geöffnet bleibt, ergeben sich die in Fig. 16 dargestellten zeitlichen Verläufe des durch den abzuschaltenden Schalter T₁ fließenden Stroms i_{C,T1} und der über den Schalter abfallenden Kollektor-Emitter Spannung u_{CE,T1}. Aufgrund der Schaltungsanordnung, insbesondere aufgrund des Resonanzkreises mit den Kondensatoren 17, 18, 47 und 48 sowie der Streuinduktivität des Transformators (Elemente 3, 16 und 33),fällt der Strom bereits vor dem Ausschalten des Schalters von einem Maximum bei ca. 500 (in beliebigen Einheiten) ab und der Schalter wird zum Zeitpunkt t0 abgeschaltet, wenn der Strom null ist. Nach dem Ausschalten des Schalters befinden sich noch freie Ladungsträger in dem Schalter. Daher steigt der Strom durch den Schalter zum Zeitpunkt t1 des Einschaltens des zweiten Schalters T₂, der in Reihe zu dem ersten Schalter T₁ geschaltet ist, an, während auch die Spannung ansteigt. Der Strom fließt dabei so lange, bis die freien Ladungsträger aus Schalter T₁ ausgeräumt sind. Die zeitlichen Verläufe gleichen denen in Fig. 4.

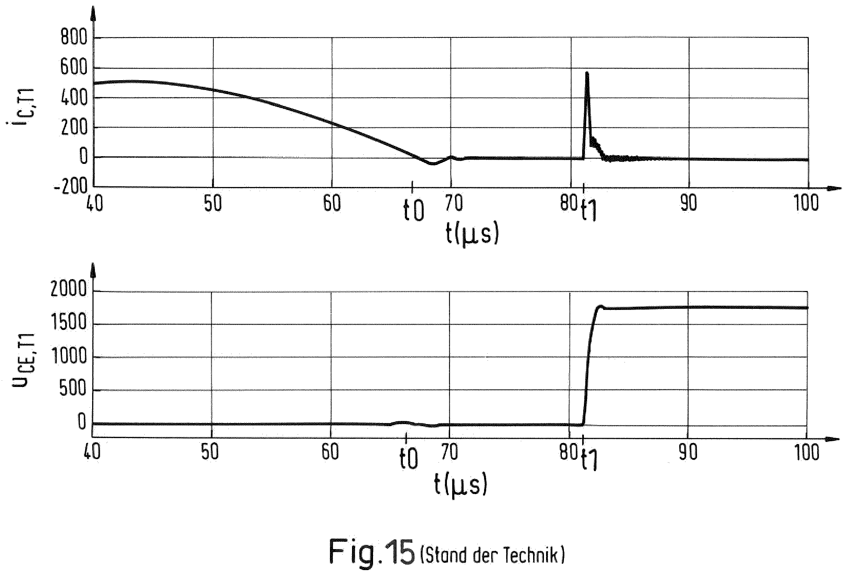

Wenn bei der Schaltungsanordnung in Fig. 12 der Zusatzschalter 15 benutzt wird, ergeben sich die in Fig. 16 dargestellten zeitlichen Verläufe der elektrischen Größen. Unten in Fig. 16 ist zusätzlich noch der Strom i_{Z} durch den Zusatzschalter 15 dargestellt. Im Ausführungsbeispiel wird der Zusatzschalter 15 zum Zeitpunkt t2 eingeschaltet, zeitversetzt nach dem Ausschalten des Hauptschalters T₁ zum Zeitpunkt t0. Man erkannt, dass der Strom zum Ausräumen der freien Ladungsträger aus T₁ sehr viel kleiner ist als in Fig. 15 und dass die Spannung über den Schalter T₁ deutlich langsamer ansteigt als in Fig. 15. Damit treten zwar weiterhin Verluste auf, die insgesamt jedoch deutlich kleiner sind als die bei einem Betrieb wie in Fig. 15 dargestellt. Insbesondere ist die Verlustleistung deutlich geringer, aber auch die Verlustenergie.

Fig. 17 zeigt schematisch Teile des zweiten Stromkreises 14. Elektrische Anschlüsse 91, 92 werden mit der zweiten Induktivität, z.B. der zweiten Induktivität gemäß Fig. 10 oder Fig. 11 verbunden. Folglich ist die zweite Induktivität zwischen die Anschlüsse 19, 92 geschaltet. Zwischen die Anschlüsse 94, 95 der Fig. 17 kann eine beliebige Anordnung mit zumindest einem steuerbaren Zusatzschalter, z.B. dem Zusatzschalter 15 gemäß Fig. 8 oder Fig. 10 geschaltet werden. Beim Einschalten des zumindest einen Zusatzschalters werden daher die Anschlüsse 94, 95 elektrisch miteinander verbunden, so dass ein Stromfluss durch die zweite Induktivität möglich ist. Die Besonderheit der in Fig. 9 gezeigten Anordnung liegt in dem zusätzlichen elektrischen oder elektronischen Element 93, über das der Anschluss 91 und der Anschluss 94 miteinander verbunden sind. Bei Diesem Element 93 kann es sich z.B. um einen Widerstand oder um eine Induktivität handeln. Das Element 93 dient der Begrenzung des Stromes, der durch den zweiten Stromkreis fließt. Es ist auch möglich, dass statt nur einem zusätzlichen Element 93 eine Parallelschaltung und/oder Serienschaltung mit mehreren zusätzlichen Elementen zur Strombegrenzung vorgesehen ist. Ferner kann auch zumindest ein solches Element zusätzlich in der Verbindung zwischen Anschlüssen 91, 95 angeordnet sein.

Fig. 18 zeigt eine Schaltungsanordnung mit Anschlüssen 94, 95, zwischen die entweder direkt die zweite Induktivität geschaltet werden kann oder z.B. die Anordnung gemäß Fig. 17. auch können die Anschlüsse 94, 95 mit den Anschlüssen 38, 39 aus Fig. 8 verbunden werden. Die Anordnung in Figur 18 stellt somit generell eine mögliche Realisierung des Zusatzschalters dar. Dies gilt entsprechend auch für die Schaltungsanordnungen der folgenden Fig. 19-22. Der Anschluss 94 ist mit einem Verbindungspunkt 97 einer Reihenschaltung aus zwei Dioden 99a, 99b verbunden. Der Anschluss 95 ist mit einem Verbindungspunkt 98 einer zweiten Reihenschaltung aus Dioden 99c, 99d geschaltet. Die Dioden 99 bilden eine Gleichrichterschaltung. Die Anschlüsse 102, 103 der Gleichrichterschaltung sind mit einer Parallelschaltung eines elektronischen steuerbaren Schalters 100 und einer Freilaufdiode 101 verbunden. Die Gleichrichterschaltung der Dioden 99 gewährleistet, dass der Schalter 100 unabhängig davon, ob das elektrische Potenzial an dem Anschluss 95 höher als an dem Anschluss 94 ist oder umgekehrt, beim Einschalten des Schalters 100 jeweils ein Strom durch den zweiten Stromkreis möglich ist.

Fig. 19 zeigt eine Variante, bei der keine Gleichrichterschaltung vorhanden ist. An die Anschlüsse 94, 95 kann wiederum entweder direkt oder indirekt die zweite Induktivität angeschlossen werden oder die Anschlüsse 94, 95 können mit den Anschlüssen 38, 39 aus Fig. 8 verbunden werden. Außerdem sind zwei Parallelschaltungen aus jeweils einem elektronischen steuerbaren Schalter 100a, 100b und einer antiparallel geschalteten Diode 101a, 101b vorgesehen. Dabei sind die beiden Parallelschaltungen zueinander in Reihe geschaltet, jedoch bei umgekehrter Durchflussrichtung der Schalter 100 bzw. der Dioden 101. Auf diese Weise kann durch Einschalten des Schalters 100a ein Stromfluss von dem Anschluss 94 durch den Schalter 100a und die Diode 101b zu dem Anschluss 95 stattfinden und somit ein Stromfluss in entsprechender Flussrichtung durch die zweite Induktivität. Durch Einschalten des Schalters 100b kann ein Stromfluss in umgekehrter Stromrichtung stattfinden. Durch entsprechende Steuerung der Schalter 100a, 100b kann daher nach dem Abschalten des ersten elektronischen Schalters ein Ausräumstrom zum Ausräumen der verbliebenen Ladungsträger in dem ersten elektronischen Schalter erzeugt werden und nach dem Ausschalten eines zweiten elektronischen Schalters, der in Reihe zu dem ersten elektronischen Schalter geschaltet ist, kann ein Ausräumstrom zum Ausräumen von verbliebenen Ladungsträgern aus dem zweiten elektronischen Schalter erzeugt werden.

Weitere Varianten bei der Ausgestaltung des zweiten Stromkreises sind möglich. Z.B. kann an die Anschlüsse 94, 95 gemäß Fig. 17 eine Snubber-Beschaltung und/oder weitere Schaltungsteile angeschlossen werden, um eine Hilfsspannung zur Verfügung zu stellen. Dabei kann auch das zusätzliche Schaltungselement 93 gemäß Fig. 17 ganz entfallen.

Eine andere Ausgestaltung mit einem Gleichrichter wie in Fig. 18 zeigt Fig. 20. Darin ist lediglich der elektronische Schalter 100 gemäß Fig. 18, der insbesondere ein IGBT ist, durch einen MOSFET 105 ersetzt.

Fig. 21 zeigt dementsprechend eine Abwandlung der Anordnung gemäß Fig. 19. Wiederum sind die Schalter 100a, 100b, die insbesondere IGBTs sind, durch MOSFETs 105a, 105b ersetzt.

Fig. 22 zeigt eine Abwandlung der Ausgestaltungen gemäß Fig. 19 und Fig. 21, bei der die beiden Schalter und antiparallel geschalteten Dioden durch zwei Thyristoren 106a, 106b ersetzt sind.

Die in Fig. 23 dargestellte Energieversorgungsanordnung ist über einen Stromabnehmer 111 an ein elektrisches Energieversorgungsnetz 110 angeschlossen. Das Potential 118 des Gleichspannungszwischenkreises ZK ist über zumindest ein Rad 119 des Schienenfahrzeugs mit der in Fig. 23 nicht dargestellten Fahrschiene elektrisch verbunden. Zwischen die Potentiale 117, 118 des Gleichspannungszwischenkreises ZK ist eine Kapazität 141 geschaltet. Sie dient der Glättung von Spannungsschwankungen und als temporärer Energiespeicher. Weiterer möglicher Bestandteil der Schaltungsanordnung, ist z.B. ein Saugkreis 115 mit einer in Reihe geschalteten Kapazität und einer Induktivität zwischen den Potentialen 117, 118.

An den Gleichspannungszwischenkreis ZK ist ein Traktionswechselrichter 131 angeschlossen, der die Gleichspannung umrichtet und einen Fahrmotor 121 mit elektrischer Energie versorgt. Alternativ können mehrere Traktionswechselrichter an denselben Gleichspannungszwischenkreis angeschlossen sein und/oder ein Traktionswechselrichter mehr als einen Fahrmotor mit Energie versorgen.

Für den Betrieb an einem Wechselspannungsnetz ist der Stromabnehmer 111 über eine Filter-Induktivität 200 mit einem ersten elektrischen Anschluss 191 eines Moduls M₁ verbunden. Über einen zweiten elektrischen Anschluss 201 ist das Modul M₁ mit einem ersten elektrischen Anschluss 192 eines zweien Moduls M₂ verbunden. Ein zweiter elektrischer Anschluss 202 des zweiten Moduls M₂ ist mit einem ersten elektrischen Anschluss 193 eines dritten Moduls M₃ verbunden. Ein zweiter elektrischer Anschluss 203 des dritten Moduls M₃ ist mit einem ersten elektrischen Anschluss 194 eines vierten Moduls M₄ verbunden. Ein zweiter elektrischer Anschluss 204 des vierten Moduls M₄ ist über weitere, nicht in Fig. 23 dargestellte Module und über zumindest das Rad 119 mit der Fahrschiene verbunden. In verschiedenen Ausführungsformen einer solchen Schaltungsanordnung kann die Anzahl der Module M variieren. Ferner können in derselben Schaltungsanordnung Module bei Bedarf hinzu oder abgeschaltet werden. Ein abgeschaltetes Modul ist nicht mehr Teil der Reihenschaltung von dem Stromabnehmer 111 über die Induktivität 200, jeweils den ersten elektrischen Anschluss 191, 192, 193, 194 sowie den zweiten elektrischen Anschluss 201, 202, 203, 204 der Module M und das Rad 119 zur Fahrschiene. Ein zugeschaltetes Modul ist jedoch Teil dieser Reihenschaltung.

Jedes Modul M weist einen ersten Gleichrichter 151, 152, 153, 154 auf, der mit dem ersten elektrischen Anschluss 191, 192, 193, 194 und dem zweiten elektrischen Anschluss 201, 202, 203, 204 verbunden ist.

An der Gleichspannungsseite des ersten Gleichrichters 151, 152, 153, 154 befinden sich zwei Gleichspannungsleitungen auf unterschiedlichem Potential, zwischen denen eine Kapazität C_{P} geschaltet ist und an die die Gleichspannungsseite eines Wechselrichters 161, 162, 163, 164 angeschlossen ist. Die Wechselspannungsseite des Wechselrichters 161, 162, 163, 164 ist über einen Kondensator Crp1, Crp2, Crp3, Crp4, einen Transformator 171, 172, 173, 174 und einen zweiten Kondensator Crs1, Crs2, Crs3, Crs4 mit der Wechselspannungsseite eines zweiten Gleichrichters 181, 182, 183, 184 verbunden. Die Gleichspannungsseite des zweiten Gleichrichters 181, 182, 183, 184 ist über zwei Gleichspannungsleitungen mit einem dritten elektrischen Anschluss 211, 212, 213, 214 bzw. einem vierten elektrischen Anschluss 221, 222, 223, 224 des Moduls M verbunden. Zwischen diese Gleichspannungsleitungen ist eine Kapazität C_{S} geschaltet. Die dritten elektrischen Anschlüsse 211, 212, 213, 214 der Module M sind unmittelbar mit dem ersten Potential 117 des Gleichspannungszwischenkreises ZK verbunden. Die vierten elektrischen Anschlusse 221, 222, 223, 224 der Module M sind unmittelbar mit dem zweiten elektrischen Potential 118 des Gleichspannungszwischenkreises verbunden. Zwischen den Potentialen 117, 118 des Gleichspannungszwischenkreises besteht die elektrische Spannung U_{ZK}.

Insbesondere kann die erfindungsgemäße Schaltungsanordnung (z. B. die Anordnung gemäß einer der Fig. 8 und 10-12 Teil des ersten Wechselrichters 161, 162, 163, 164 oder des zweiten Gleichrichters 181, 182, 183, 184 sein. Die Kombination des ersten Wechselrichters 161, 162, 163, 164, des Transformator 171, 172, 173, 174 und des zweiten Gleichrichters 181, 182, 183, 184 bildet einen DC/DC-Konverter und kann z. B. jeweils wie anhand von Fig. 8, 10-12 beschrieben ausgestaltet sein.

## Patentansprüche

1. Schaltungsanordnung (51; 61; 71), aufweisend:
- einen ersten elektronischen Schalter (T₁), nämlich einen IGBT mit einem Kollektor, einem Emitter und einem isolierten Gate,
- zumindest Teile eines ersten Stromkreises, in dem während dem Betrieb der Anordnung bei eingeschaltetem erstem elektronischem Schalter (T₁) ein elektrischer Strom über den Kollektor und den Emitter durch den ersten elektronischen Schalter (T₁) fließt,
- eine erste Steuerung zum Ein- und Ausschalten des ersten elektronischen Schalters (T₁), wobei die erste Steuerung ausgestaltet ist, den ersten elektronischen Schalter (T₁) wiederholt ein- und auszuschalten und auf diese Weise - optional gemeinsam durch den Betrieb zumindest eines weiteren elektronischen Schalters (T₂, T₇, T₈) der Schaltungsordnung (51; 61; 71) - einen sich zyklisch wiederholenden Prozess zu bewirken, bei dem der elektrische Strom durch den ersten elektronischen Schalter (T₁) in jedem Zyklus auf einen Strom-Maximalwert ansteigt und danach stetig abnimmt und bei dem der elektrische Strom in jedem Zyklus auf null abnimmt,
- einen steuerbaren Zusatzschalter (15), der durch die erste Steuerung oder durch eine zusätzliche zweite Steuerung steuerbar ist,
wobei die erste Steuerung und die Steuerung des Zusatzschalters (15) derart ausgestaltet sind, dass der erste elektronische Schalter (T₁) erst dann ausgeschaltet wird und der Zusatzschalter (15) erst dann eingeschaltet wird, wenn ein durch den ersten elektronischen Schalter (T₁) fließender Strom kleiner als 10 % eines Strom-Maximalwertes ist, den der Strom zuvor erreicht hat, wobei der Strom nach dem Verlassen des Strom-Maximalwertes stetig abgenommen hat,
und wobei durch Einschalten des Zusatzschalters (15) ein Ausräumstrom bewirkt wird, der in dieselbe Richtung über den Kollektor und den Emitter durch den ersten elektronischen Schalter (T₁) fließt wie zuvor der stetig abnehmende Strom und der Ladungsträger, die in dem ersten elektronischen Schalter (T₁) nach dessen Ausschalten verblieben sind, aus diesem ausräumt.

2. Schaltungsanordnung (51; 61; 71) nach Anspruch 1, wobei die Schaltungsanordnung (51; 61; 71) aufweist:
- eine erste Induktivität (3), durch die während dem Betrieb der Anordnung bei eingeschaltetem erstem elektronischem Schalter (T₁) ein elektrischer Strom fließt,
- eine zweite Induktivität (13), die magnetisch mit der ersten Induktivität (3) gekoppelt ist,
- einen zweiten Stromkreis (14), in dem die zweite Induktivität (13) angeordnet ist, und
wobei der Zusatzschalter (15) in dem zweiten Stromkreis (14) angeordnet ist, sodass durch Einschalten des Zusatzschalters (15) und durch die magnetische Kopplung der zweiten Induktivität (13) mit der ersten Induktivität (3) ein Strom fließt, der in dem ersten elektronischen Schalter verbliebene Ladungsträger aus diesem ausräumt.

3. Schaltungsanordnung (51; 61; 71) nach Anspruch 2, wobei der zweite Stromkreis (14) einen Gleichrichter (99) aufweist, sodass Strom durch den Zusatzschalter (100; 105) unabhängig davon, in welcher Richtung der zweite Stromkreis (14) von Strom durchflossen wird, immer in derselben Richtung fließt.

4. Schaltungsanordnung (51; 61; 71) nach Anspruch 2, wobei der zweite Stromkreis (14) einen ersten (100a; 105a) und einen zweiten Zusatzschalter (100b; 105b) aufweist, wobei der erste Zusatzschalter (100a; 105a) in seinem eingeschalteten Zustand einen Stromfluss durch den zweiten Stromkreis (14) in einer ersten Richtung ermöglicht und der zweite Zusatzschalter (100b; 105b) in seinem eingeschalteten Zustand einen Stromfluss durch den zweiten Stromkreis (14) in der entgegen gesetzten Richtung ermöglicht.

5. Schaltungsanordnung (51; 61; 71) nach einem der Ansprüche 2-4, wobei die Schaltungsanordnung einen Transformator (29) aufweist und wobei die erste Induktivität (3) Teil des Transformators (29) auf einer Primärseite des Transformators (29) ist.

6. Schaltungsanordnung (51; 61; 71) nach einem der vorhergehenden Ansprüche, wobei die Schaltungsanordnung (51; 61; 71) einen zweiten elektronischen Schalter (T₂) aufweist, der über eine elektrisch leitende Verbindung (6) mit dem ersten elektronischen Schalter (T₁) zu einer ersten Reihenschaltung verbunden ist, wobei die erste Steuerung oder die zusätzliche zweite Steuerung derart zum Einschalten des Zusatzschalters (15) ausgestaltet ist, dass der Zusatzschalter (15) während Zeitintervallen eingeschaltet ist, in denen sowohl der erste elektronische Schalter (T₁) als auch der zweite elektronische Schalter (T₂) ausgeschaltet ist.

7. Antriebseinrichtung für ein Fahrzeug, insbesondere ein Schienenfahrzeug, wobei die Antriebseinrichtung die Schaltungsanordnung nach einem der vorhergehenden Ansprüche aufweist und über einen netzseitigen Anschluss (111) elektrisch oder magnetisch an ein elektrisches Versorgungsnetz (110) anschließbar ist, wobei die Schaltungsanordnung (51; 61; 71) mit dem ersten Stromkreis an den netzseitigen Anschluss (110) angeschlossen ist und ein motorseitiger Anschluss (211, 221) der Schaltungsanordnung (51; 61; 71) magnetisch mit einer ersten Induktivität (3), durch die während dem Betrieb der Schaltungsanordnung (51; 61; 71) bei eingeschaltetem erstem elektronischem Schalter (T₁) ein elektrischer Strom fließt, verbunden ist, sodass beim Betrieb des Fahrzeugs Energie von dem netzseitigen Anschluss (111) über die erste Induktivität (3) und den motorseitigen Anschluss (211, 221) zu einem Antriebsmotor (121) des Fahrzeugs übertragbar ist.

8. Generatoreinrichtung zum Übertragen von elektrischer Energie, die durch einen elektrischen Generator, insbesondere einen durch Wind angetriebenen Generator, erzeugt wird, wobei die Generatoreinrichtung die Schaltungsanordnung (51; 61; 71) nach einem der Ansprüche 1 bis 6 aufweist und über einen generatorseitigen Anschluss an den Generator anschließbar ist, wobei die Schaltungsanordnung (51; 61; 71) mit dem ersten Stromkreis an den generatorseitigen Anschluss (211, 221) angeschlossen ist und ein netzseitiger Anschluss (111) der Schaltungsanordnung (51; 61; 71) zum Anschließen an ein elektrisches Versorgungsnetz (110) magnetisch mit einer ersten Induktivität (3), durch die während dem Betrieb der Schaltungsanordnung (51; 61; 71) bei eingeschaltetem erstem elektronischem Schalter (T₁) ein elektrischer Strom fließt, verbunden ist, sodass beim Betrieb des Generators Energie von dem generatorseitigen (211, 221) über die erste Induktivität (3) über den netzseitigen Anschluss (111) zu dem elektrischen Versorgungsnetz (110) übertragbar ist.

9. Verfahren zum Betreiben einer Schaltungsanordnung (51; 61; 71), die Folgendes aufweist:
- einen ersten elektronischen Schalter (T₁), nämlich einen IGBT mit einem Kollektor, einem Emitter und einem isolierten Gate,
- zumindest Teile eines ersten Stromkreises, in dem der erste elektronische Schalter (T₁) angeordnet sind,
wobei der erste elektronische Schalter (T₁) wiederholt ein- und ausgeschaltet wird und auf diese Weise - optional gemeinsam durch den Betrieb zumindest eines weiteren elektronischen Schalters (T₂, T₇, T₈) der Schaltungsordnung (51; 61; 71) - ein sich zyklisch wiederholender Prozess bewirkt wird, bei dem in jedem Zyklus bei eingeschaltetem erstem elektronischem Schalter (T₁) ein elektrischer Strom über den Kollektor und den Emitter durch den ersten elektronischen Schalter (T₁) fließt, der auf einen Strom-Maximalwert ansteigt und danach stetig abnimmt und der in jedem Zyklus auf null abnimmt,
**dadurch gekennzeichnet, dass**
der erste elektronische Schalter (T₁) erst dann ausgeschaltet wird und ein Zusatzschalter (15) erst dann eingeschaltet wird, wenn der Strom durch den ersten elektronischen Schalter (T₁) kleiner als 10 % eines Strom- Maximalwertes ist, den der Strom zuvor erreicht hat, wobei der Strom nach dem Verlassen des Strom-Maximalwertes stetig abgenommen hat,
und durch Einschalten des Zusatzschalters (15) ein Ausräumstrom bewirkt wird, der in dieselbe Richtung über den Kollektor und den Emitter durch den ersten elektronischen Schalter (T₁) fließt wie zuvor der stetig abnehmende Strom und der nach dem Ausschalten des ersten elektronischen Schalters (T₁) in diesem verbliebene Ladungsträger aus diesem ausräumt.

10. Verfahren nach dem vorhergehenden Anspruch, wobei
- die Schaltungsanordnung (51; 61; 71) mit einer ersten Induktivität (3) betrieben wird, durch die bei eingeschaltetem erstem elektronischem Schalter (T₁) ein elektrischer Strom fließt,
- die erste Induktivität (3) mit einer zweiten Induktivität (13) magnetisch gekoppelt betrieben wird, die in einem zweiten Stromkreis (14) angeordnet ist, und
- durch das Einschalten des Zusatzschalters (15) und durch die magnetische Kopplung der zweiten Induktivität (13) mit der ersten Induktivität (3) ein Strom fließt, der in dem ersten elektronischen Schalter verbliebene Ladungsträger aus diesem ausräumt.

11. Verfahren nach Anspruch 9 oder 10, wobei der erste elektronische Schalter (T₁) und ein zweiter elektronischer Schalter (T₂) der Schaltungsanordnung (51; 61; 71), der über eine elektrisch leitende Verbindung (6) mit dem ersten elektronischen Schalter (T₁) zu einer ersten Reihenschaltung verbunden ist, wechselweise ein- und ausgeschaltet werden, sodass jeweils bei einem eingeschalteten Schalter (T₁, T₂) ein elektrischer Strom durch einen Stromkreis fließt, der elektrisch mit der elektrisch leitenden Verbindung (6) der ersten Reihenschaltung verbunden ist, und wobei durch Einschalten des Zusatzschalters (105a, 105b) ein Stromfluss während Zeitintervallen erzeugt wird, in denen sowohl der erste elektronische Schalter (T₁) als auch der zweite elektronische Schalter (T₂) ausgeschaltet ist.

12. Verfahren nach dem vorhergehenden Anspruch, wobei eine Richtung des Stromflusses in dem zweiten Stromkreis (14) abhängig davon gesteuert wird, ob vorangehend ein Strom durch den ersten (T₁) oder zweiten (T₂) elektronischen Schalter (T₁) geflossen ist.

## Claims

1. A circuit arrangement (51; 61; 71), comprising:
- a first electronic switch (T₁), namely an IGBT with a collector, an emitter and an insulated gate,
- at least parts of a first circuit, in which, during operation of the arrangement when the first electronic switch (T₁) is switched on, an electrical current flows across the collector and emitter through the first electronic switch (T₁),
- a first controller for switching the first electronic switch (T₁) on and off, wherein the first controller is designed to repeatedly switch the first electronic switch (T₁) on and off and in this way - optionally jointly by the operation of at least one further electronic switch (T₂, T₇, T₅) of the circuit arrangement (51; 61; 71) - to bring about a cyclically repeating process, in which the electrical current through the first electronic switch (T₁) rises in each cycle to a current maximum value and then decreases continuously, and in which the electrical current decreases to zero in each cycle,
- a controllable auxiliary switch (15), which can be controlled by the first controller or by an additional second controller,
wherein the first controller and the controller of the auxiliary switch (15) are designed in such a way that the first electronic switch (T₁) is switched off and the auxiliary switch (15) is switched on only when a current flowing through the first electronic switch (T₁) is less than 10% of a current maximum value, which the current reached previously, wherein the current has decreased continuously after dropping from the current maximum value,
and wherein, by switching on the auxiliary switch (15), a clearing current is effected, which flows across the collector and the emitter through the first electronic switch (T₁) in the same direction as before the continuously decreasing current and clears the charge carriers remaining in the first electronic switch (T₁) from the first electronic switch once this has been switched off.

2. The circuit arrangement (51; 61; 71) according to claim 1, wherein the circuit arrangement (51; 61; 71) comprises:
- a first inductance (3), through which an electrical current flows during operation of the arrangement when the first electronic switch (T₁) is switched on,
- a second inductance (13), which is magnetically coupled to the first inductance (3),
- a second circuit (14), in which the second inductance (13) is arranged, and
wherein the auxiliary switch (15) is arranged in the second circuit (14), so that, by switching on the auxiliary switch (15) and by means of the magnetic coupling of the second inductance (13) to the first inductance (3), a current flows which clears the charge carriers remaining in the first electronic switch from said first electronic switch.

3. The circuit arrangement (51; 61; 71) according to claim 2, wherein the second circuit (14) has a rectifier (99), so that current flows through the auxiliary switch (100; 105) always in the same direction regardless of the direction in which current passes through the second circuit (14).

4. The circuit arrangement (51; 61; 71) according to claim 2, wherein the second circuit (14) comprises a first auxiliary switch (100a; 105a) and a second auxiliary switch (100b; 105b), wherein the first auxiliary switch (100a; 105a) in its switched-on state enables a flow of current through the second circuit (14) in a first direction, and the second auxiliary switch (100b; 105b) in its switched-on state enables a flow of current through the second circuit (14) in the opposite direction.

5. The circuit arrangement (51; 61; 71) according to any one of claims 2-4, wherein the circuit arrangement comprises a transformer (29), and wherein the first inductance (3) is part of the transformer (29) on a primary side of the transformer (29).

6. The circuit arrangement (51; 61; 71) according to any one of the preceding claims, wherein the circuit arrangement (51; 61; 71) comprises a second electronic switch (T₂) which is connected by means of an electrically conductive connection (6) to the first electronic switch (T₁) to form a first series connection, wherein the first controller or the additional second controller is designed to switch on the auxiliary switch (15) in such a way that the auxiliary switch (15) is switched on during time intervals in which both the first electronic switch (T₁) and the second electronic switch (T₂) are switched off.

7. A drive means for a vehicle, in particular a rail vehicle, wherein the drive means comprises the circuit arrangement according to any one of the preceding claims and can be electrically or magnetically connected by means of a network-side connection (111) to an electrical supply network (110), wherein the circuit arrangement (51; 61; 71) is connected by means of the first circuit to the network-side connection (110) and a motor-side connection (211, 221) of the circuit arrangement (51; 61; 71) is connected magnetically to a first inductance (3), through which an electrical current flows during operation of the circuit arrangement (51; 61; 71) when the first electronic switch (T₁) is switched on, so that, when the vehicle is in operation, energy can be transmitted from the network-side connection (111) via the first inductance (3) and the motor-side connection (211, 221) to a drive motor (121) of the vehicle.

8. A generator means for transmitting electrical power generated by an electrical generator, in particular a generator driven by wind, wherein the generator means comprises the circuit arrangement (51; 61; 71) according to any one of claims 1 to 6 and can be connected to the generator by means of a generator-side connection, wherein the circuit arrangement (51; 61; 71) is connected by means of the first circuit to the generator-side connection (211, 221) and a network-side connection (111) of the circuit arrangement (51; 61; 71) for connection to an electrical supply network (110) is connected magnetically to a first inductance (3), through which an electrical current flows during operation of the circuit arrangement (51; 61; 71) when the first electronic switch (T₁) is switched on, so that, when the generator is in operation, energy can be transmitted from the generator-side connection (211, 221) via the first inductance (3) via the network-side connection (111) to the electrical supply network (110).

9. A method for operating a circuit arrangement (51; 61; 71), which comprises the following:
- a first electronic switch (T₁), namely an IGBT with a collector, an emitter and an insulated gate,
- at least parts of a first circuit, in which the first electronic switch (T₁) is arranged,
wherein the first electronic switch (T₁) is repeatedly switched on and off and in this way - optionally jointly by the operation of at least one further electronic switch (T₂, T₇, T₅) of the circuit arrangement (51; 61; 71) - a cyclically repeating process is brought about, in which an electrical current flows across the collector and the emitter through the first electronic switch (T₁) in each cycle when the first electronic switch (T₁) is switched on, which current rises to a current maximum value and then decreases continuously, and decreases to zero in each cycle, **characterised in that**
the first electronic switch (T₁) is switched off and an auxiliary switch (15) is switched on only when the current flowing through the first electronic switch (T₁) is less than 10% of a current maximum value, which the current reached previously, wherein the current has decreased continuously after dropping from the current maximum value,
and, by switching on the auxiliary switch (15), a clearing current is effected, which flows across the collector and the emitter through the first electronic switch (T₁) in the same direction as before the continuously decreasing current and clears the charge carriers remaining in the first electronic switch (T₁) from the first electronic switch once this has been switched off.

10. The method according to the preceding claim, wherein
- the circuit arrangement (51; 61; 71) is operated with a first inductance (3), through which an electrical current flows when the first electronic switch (T₁) is switched on,
- the first inductance (3) is operated magnetically coupled to a second inductance (13), which is arranged in a second circuit (14), and
- by switching on the auxiliary switch (15) and by means of the magnetic coupling of the second inductance (13) to the first inductance (3), a current flows which clears charge carriers remaining in the first electronic switch from said first electronic switch.

11. The method according to claim 9 or 10, wherein the first electronic switch (T₁) and a second electronic switch (T₂) of the circuit arrangement (51; 61; 71), which is connected by means of an electrically conductive connection (6) to the first electronic switch (T₁) to form a first series connection, are switched on and off alternately, in such a way that, when a switch (T₁, T₂) is switched on, an electrical current flows through a circuit which is electrically connected to the electrically conductive connection (6) of the first series connection, and wherein, by switching on the auxiliary switch (105a, 105b), a flow of current is generated during time intervals in which both the first electronic switch (T₁) and the second electronic switch (T₂) are switched off.

12. The method according to the preceding claim, wherein a direction of the flow of current in the second circuit (14) is controlled depending on whether a current has passed beforehand through the first electronic switch (T₁) or the second electronic switch (T₂).

## Revendications

1. Ensemble circuit (51 ; 61 ; 71) présentant :
- un premier commutateur électronique (T₁), à savoir un IGBT avec un collecteur, un émetteur et une grille isolée,
- au moins des parties d'un premier circuit électrique dans lequel, pendant le fonctionnement de l'ensemble avec le premier commutateur électronique (T₁) activé, un courant électrique s'écoule via le collecteur et l'émetteur à travers le premier commutateur électronique (T₁),
- une première commande pour activer et désactiver le premier commutateur électronique (T₁), dans lequel la première commande est réalisée pour activer et désactiver de manière répétée le premier commutateur électronique (T₁) et - en option en commun grâce au fonctionnement d'au moins un autre commutateur électronique (T₂, T₇, T₈) de l'ensemble circuit (51 ; 61 ; 71) - à produire de cette manière un processus se répétant cycliquement où le courant électrique à travers le premier commutateur électronique (T₁) s'élève dans chaque cycle à une valeur maximale de courant et diminue ensuite continûment et où le courant électrique diminue jusqu'à zéro dans chaque cycle,
- un commutateur additionnel commandable (15), lequel peut être commandé par la première commande ou par une deuxième commande additionnelle,
dans lequel la première commande et la commande du commutateur additionnel (15) sont réalisées de manière à ce que le premier commutateur électronique (T₁) soit seulement désactivé et le commutateur additionnel (15) soit seulement activé lorsqu'un courant s'écoulant à travers le premier commutateur électronique (T₁) est inférieur à 10 % d'une valeur maximale de courant atteinte précédemment par le courant, dans lequel, après avoir abandonné la valeur maximale de courant, le courant a diminué continûment,
et dans lequel, en activant le commutateur additionnel (15), un courant d'évacuation est produit, lequel s'écoule dans la même direction via le collecteur et l'émetteur à travers le premier commutateur électronique (T₁) que précédemment le courant diminuant continûment et lequel évacue des porteurs de charge, lesquels sont restés dans le premier commutateur électronique (T₁) après la désactivation de celui-ci, hors de celui-ci.

2. Ensemble circuit (51 ; 61 ; 71) selon la revendication 1, dans lequel l'ensemble circuit (51 ; 61 ; 71) présente :
- une première inductance (3) à travers laquelle un courant électrique s'écoule pendant le fonctionnement de l'ensemble en cas de premier commutateur électronique (T₁) activé,
- une deuxième inductance (13) couplée magnétiquement avec la première inductance (3),
- un deuxième circuit électrique (14) dans lequel la deuxième inductance (13) est disposée, et dans lequel le commutateur additionnel (15) est disposé dans le deuxième circuit électrique (14) de sorte que par activation du commutateur additionnel (15) et par le couplage magnétique de la deuxième inductance (13) avec la première inductance (3) un courant s'écoule, lequel évacue des porteurs de charge restés dans le premier commutateur électronique hors de celui-ci.

3. Ensemble circuit (51 ; 61 ; 71) selon la revendication 2, dans lequel le deuxième circuit électrique (14) présente un redresseur (99) de manière à ce que du courant à travers le commutateur additionnel (100 ; 105) s'écoule toujours dans la même direction indépendamment de la direction dans laquelle le deuxième circuit électrique (14) est parcouru par du courant.

4. Ensemble circuit (51 ; 61 ; 71) selon la revendication 2, dans lequel le deuxième circuit électrique (14) présente un premier (100a ; 105a) et un deuxième commutateur additionnel (100b ; 105b), dans lequel le premier commutateur additionnel (100a ; 105a) permet, dans son état activé, un écoulement de courant à travers le deuxième circuit électrique (14) dans une première direction et le deuxième commutateur additionnel (100b ; 105b) permet, dans son état activé, un écoulement de courant à travers le deuxième circuit électrique (14) dans la direction opposée.

5. Ensemble circuit (51 ; 61 ; 71) selon l'une des revendications 2-4, dans lequel l'ensemble circuit présente un transformateur (29) et dans lequel la première inductance (3) est une partie du transformateur (29) d'un côté primaire du transformateur (29).

6. Ensemble circuit (51 ; 61 ; 71) selon l'une des revendications précédentes, dans lequel l'ensemble circuit (51 ; 61 ; 71) présente un deuxième commutateur électronique (T₂) relié via une liaison électroconductrice (6) au premier commutateur électronique (T₁) pour donner une première connexion en série, dans lequel la première commande ou la deuxième commande additionnelle est réalisée pour l'activation du commutateur additionnel (15) de manière à ce que le commutateur additionnel (15) soit activé pendant des intervalles de temps dans lesquels le premier commutateur électronique (T₁) tout comme également le deuxième commutateur électronique (T2) sont désactivés.

7. Dispositif d'entraînement pour un véhicule, en particulier un véhicule ferroviaire, dans lequel le dispositif d'entraînement présente l'ensemble circuit selon l'une des revendications précédentes et peut être raccordé électriquement ou magnétiquement via un raccordement côté réseau (111) à un réseau d'alimentation électrique (110), dans lequel l'ensemble circuit (51 ; 61 ; 71) est raccordé avec le premier circuit électrique au raccordement côté réseau (110), et un raccordement côté moteur (211, 221) de l'ensemble circuit (51 ; 61 ; 71) est relié magnétiquement à une première inductance (3) à travers laquelle un courant électrique s'écoule pendant le fonctionnement de l'ensemble circuit (51 ; 61 ; 71) en cas de premier commutateur électronique (T₁) allumé, de sorte que lors du fonctionnement du véhicule, de l'énergie peut être transmise du raccordement côté réseau (111) via la première inductance (3) et le raccordement côté moteur (211, 221) à un moteur d'entraînement (121) du véhicule.

8. Dispositif générateur pour la transmission d'énergie électrique, laquelle est générée par un générateur électrique, en particulier un générateur entraîné par du vent, dans lequel le dispositif générateur présente l'ensemble circuit (51 ; 61 ; 71) selon l'une des revendications 1 à 6 et peut être raccordé au générateur via un raccordement côté générateur, dans lequel l'ensemble circuit (51 ; 61 ; 71) est raccordé avec le premier circuit électrique au raccordement côté générateur (211, 221), et un raccordement côté réseau (111) de l'ensemble circuit (51 ; 61 ; 71) pour le raccordement à un réseau d'alimentation électrique (110) est relié magnétiquement à une première inductance (3) à travers laquelle s'écoule un courant électrique pendant le fonctionnement de l'ensemble circuit (51 ; 61 ; 71) en cas de premier commutateur électronique (T₁) activé de sorte que lors du fonctionnement du générateur, de l'énergie peut être transmise du raccordement côté générateur (211, 221) via la première inductance (3), via le raccordement côté réseau (111) au réseau d'alimentation électrique (110).

9. Procédé pour faire fonctionner un ensemble circuit (51 ; 61 ; 71), lequel présente ce qui suit :
- un premier commutateur électronique (T₁), à savoir un IGBT avec un collecteur, un émetteur et une grille isolée,
- au moins des parties d'un premier circuit électrique dans lequel le premier commutateur électronique (T₁) est disposé,
dans lequel le premier commutateur électronique (T₁) est activé et désactivé de manière répétée et - en option, en commun grâce au fonctionnement d'au moins un autre commutateur électronique (T₂, T₇, T₈) de l'ensemble circuit (51 ; 61 ; 71) - un processus se répétant de manière cyclique est produit de cette manière avec lequel, dans chaque cycle en cas de premier commutateur électronique (T₁) activé, un courant électrique s'écoule via le collecteur et l'émetteur à travers le premier commutateur électronique (T₁), lequel s'élève à une valeur maximale de courant et diminue ensuite continûment et lequel diminue continûment jusqu'à zéro dans chaque cycle,
**caractérisé en ce**
**que** le premier commutateur électronique (T₁) est seulement désactivé et un commutateur additionnel (15) est seulement activé lorsque le courant à travers le premier commutateur électronique (T₁) est inférieur à 10 % d'une valeur maximale de courant atteinte précédemment par le courant, dans lequel le courant, après avoir quitté la valeur maximale de courant, a diminué continûment,
et **que** par activation du commutateur additionnel (15) un courant d'évacuation est produit, lequel s'écoule dans la même direction via le collecteur et l'émetteur à travers le premier commutateur électronique (T₁) que précédemment le courant diminuant continûment et lequel, après la désactivation du premier commutateur électronique (T₁), évacue des porteurs de charge restés dans celui-ci hors de celui-ci.

10. Procédé selon la revendication précédente, dans lequel
- on fait fonctionner l'ensemble circuit (51 ; 61 ; 71) avec une première inductance (3) à travers laquelle un courant électrique s'écoule en cas de premier commutateur électronique (T₁) activé,
- on fait fonctionner la première inductance (3) de manière couplée magnétiquement avec une deuxième inductance (13), laquelle est disposée dans un deuxième circuit électrique (14), et
- par activation du commutateur additionnel (15) et par le couplage magnétique de la deuxième inductance (13) avec la première inductance (3) un courant s'écoule, lequel évacue des porteurs de charge restés dans le premier commutateur électronique hors de celui-ci.

11. Procédé selon la revendication 9 ou 10, dans lequel le premier commutateur électronique (T₁) et un deuxième commutateur électronique (T₂) de l'ensemble circuit (51 ; 61 ; 71), lequel est relié via une liaison électroconductrice (6) au premier commutateur électronique (T₁) pour donner une première connexion série, sont tour à tour activés et désactivés de sorte qu'en cas d'un commutateur (T₁, T₂) respectivement activé, un courant électrique s'écoule à travers un circuit électrique, lequel est relié électriquement à la liaison électroconductrice (6) de la première connexion série, et dans lequel par activation du commutateur additionnel (105a, 105b), un écoulement de courant est généré pendant des intervalles de temps dans lesquels le premier commutateur électronique (T₁) tout comme également le deuxième commutateur électronique (T₂) sont désactivés.

12. Procédé selon la revendication précédente, dans lequel une direction de l'écoulement de courant dans le deuxième circuit électrique (14) est commandée en fonction du fait qu'un courant s'est préalablement écoulé à travers le premier (T₁) ou le deuxième (T₂) commutateur électronique (T₁).
